# EUROPEAN PATENT APPLICATION

(11) **EP 4 821 965 A1**
(43) Date of publication of application: **14.10.2026**
(21) Application number: 24900322.9
(22) Date of filing: 25.10.2024
(51) Int. Cl.: C08G 59/32, C08G 59/40, C09J 7/30, C09J 11/04, C09J 11/06, C09J 163/00, H01L 23/29, H01L 23/31

(54) **EPOXY RESIN COMPOSITION, RESIN PASTE, RESIN FILM, AND SEMICONDUCTOR DEVICE**

(30) Priority: 08.12.2023 JP 2023207573
(71) Applicant: ASAHI KASEI KABUSHIKI KAISHA, Tokyo 100-0006 (JP)
(72) Inventor: KOBAYASHI, Naohiro, Tokyo 100-0006 (JP); YOSHIDA, Masanori, Tokyo 100-0006 (JP)
(74) Representative: Hoffmann Eitle
(86) International application number: PCT/JP2024/038214
(87) International publication number: WO 2025/121026

(57) **Abstract**

Provided is an epoxy resin composition comprising component (A): an epoxy resin, and component (B): a specific compound represented by the formula (1) and/or a specific compound represented by the formula (2), wherein the component (A) comprises at least one trifunctional or higher polyfunctional epoxy resin, and a slope α of a line satisfies 690 ≤ α ≤ 1000, the line being obtained by plotting Lnt (ordinate) against 1/T (abscissa) wherein a time for a viscosity to reach 10000 Pa·s based on a time when the temperature T°C has been attained is defined as t minute:

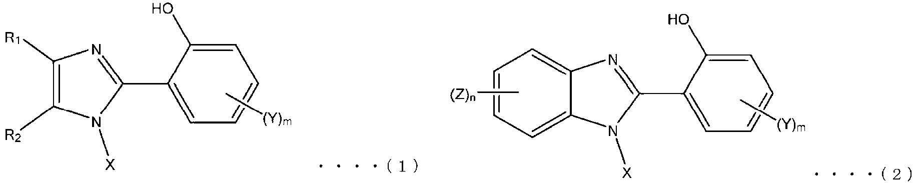

## Description

### Technical Field

The present invention relates to an epoxy resin composition, a resin paste, a resin film, and a semiconductor equipment.

### Background Art

Epoxy resins have heretofore been utilized for a wide range of purposes such as insulating materials, sealing materials, adhesive materials, and conductive materials for electric and electronic components including semiconductor devices, matrix resins for fiber-reinforced plastics, and impregnant fixatives for motor coils.

Among others, epoxy resin compositions which are excellent in adhesion and exhibit high reliability are used in sealing materials or adhesive materials for semiconductor equipment. For example, an epoxy resin, a curing agent such as a phenol resin having reactivity with the epoxy resin, and a curing accelerator which accelerates the reaction of the epoxy resin and the curing agent are generally used as components constituting the epoxy resin compositions.

With recent increase in performance of electronics, semiconductor equipment is more highly integrated, and a solder joint in the semiconductor equipment has an increasingly narrow pitch and narrow gap. Since individual semiconductor chips also have a larger area, resin pastes that can penetrate and fill into narrow space or resin films that can integrally seal and bond the whole chip having a wide area are required for sealing materials for semiconductor equipment.

Sealing materials and adhesive materials for use in semiconductor equipment are required to have a high glass transition temperature as well as small reduction in modulus of elasticity in a high-temperature region equal to or higher than the glass transition temperature, because the quantity of heat generated by such semiconductor equipment is increased along with higher densities of electronic components and larger capacities of electronic information to be handled. This is because, if the modulus of elasticity differs largely between ordinary temperature and the glass transition temperature or higher, the physical properties of a cured layer are largely altered upon heat generation of electronics so that sealing or adhesion reliability tends to be reduced.

Meanwhile, stacked MCP (multichip package) in which semiconductor chips are stacked in multiple layers is being adopted for memory packages in electronics typified by mobile phones and the like. Resin films are mainly used in the adhesion between a circuit substrate and a semiconductor chip or the adhesion between semiconductor chips in the stacked MCP because of the advantages of being a uniform thickness and causing little inclination in the chips.

Resin films having a smaller film thickness are also required as such resin films for smaller and more highly integrated equipment. Furthermore, these resin films are required to have a high glass transition temperature and suppress reduction in modulus of elasticity in a high-temperature region, as described above, because the quantity of heat generated by semiconductor chips is increased along with finer wiring and a higher density.

As for sealing materials or adhesive materials for semiconductor equipment, for example, a resin composition in a paste form made of a trifunctional epoxy resin, a curing agent such as aromatic amine, a filler, and the like is known as a material that is cured after filling into the space between each electronic member and a circuit substrate (see, for example, Patent Document 1). Electric connection and sealing may be performed at the same time by the thermal pressure bonding and curing of a semiconductor chip into which a resin film is supplied in advance to a circuit substrate. For example, a film-type adhesive material made of a polyfunctional epoxy resin, a curing agent, a filler, and the like is known as such a material (see, for example, Patent Document 2).

For example, a film-type adhesive material made of a polyfunctional epoxy resin, a curing agent such as imidazole, a filler, and the like is known as a resin film that bonds a semiconductor chip to a circuit substrate and bonds semiconductor chips (for example, Patent Document 3).

As for the stability and rapid curability of epoxy resin compositions, for example, a curable composition is disclosed which comprises a curing agent for an anionic curable compound consisting of an imidazole compound having a substituted phenyl group at position 2 of an imidazole ring (see, for example, Patent Document 4). As disclosed therein, the curable composition can be subjected to selective curing reaction of an epoxy resin in a high-temperature region around 150°C and is also excellent in preservation stability.

### List of Prior Art Documents

### Patent Document

Patent Document 1: Japanese Patent No. 7103401
Patent Document 2: Japanese Patent No. 6536281
Patent Document 3: Japanese Patent No. 7178529
Patent Document 4: Japanese Patent Laid-Open No. 2016-29152

### Summary of Invention

### Problems to be Solved by Invention

As disclosed in Patent Documents 1 to 3, a method of blending a trifunctional or higher polyfunctional epoxy resin (hereinafter, also simply referred to as a "polyfunctional epoxy resin") into an epoxy resin composition to increase the cross-link density of a cured layer is generally effective for achieving a high glass transition temperature and the suppression of reduction in modulus of elasticity at a high temperature. However, as a result of conducting studies, the present inventors have confirmed that in the presence of the polyfunctional epoxy resin, curing occurs before the completion of reaction of the functional group of the epoxy resin or a curing agent due to fast thickening at the initial stage of heating so that a sufficient cross-link density cannot be obtained, disadvantageously leading to a lower glass transition temperature than expected, or marked reduction in modulus of elasticity at a high temperature. Particularly, it has heretofore been difficult for the glass transition temperature to obtain a glass transition temperature equal to or higher than a curing temperature even if the polyfunctional epoxy resin is blended. Thus, the conventional techniques are susceptible to improvement.

For the sealing and adhesion of increasingly densified electronic components, the epoxy resin composition used has homogeneity, which is important, and ideally contains no solid dispersion-type curing agent or curing accelerator. Use of such a solid dispersion-type curing agent causes clogging, which deteriorates filling properties into space and makes it difficult to seal the whole semiconductor chip. For a resin film, film formability tends to be deteriorated due to particle residues generated in preparing a thin film. Thus, a problem of the solid dispersion-type curing agent or curing accelerator as used in Patent Documents 2 and 3 is that cases that require more dense sealing or adhesion cannot be coped with.

On the other hand, Patent Document 4 shows that the curing agent for an anionic curable compound disclosed therein can achieve stability during storage and curability in a high-temperature region around 150°C. However, the patent literature does not specify any composition that satisfies both of a high glass transition temperature and the suppression of reduction in modulus of elasticity at a high temperature required for purposes such as sealing materials or adhesive materials for densified semiconductor equipment. Thus, there is still room for discussion.

In addition, as a result of conducting studies, the present inventors have confirmed that the curing agent for an anionic curable compound disclosed in Patent Document 4 presents problems with filling properties when used alone. The filling properties are important for adequately and tightly spreading an epoxy resin composition according to space or the shape of each semiconductor chip or electronic component in the sealing or adhesion of electronic components. For obtaining favorable filling properties, it is necessary to be able to secure the homogeneity mentioned above as well as a time for which an epoxy resin composition can maintain a low viscous state when heated to, for example, 110°C to 130°C. A short time for which the low viscous state is maintained causes poor filling so that sealing or adhesion excellent in reliability cannot be performed.

Accordingly, an object of the present invention is to provide, in light of the problems of the conventional techniques mentioned above, an epoxy resin composition that has completely uniform and sufficient filling properties and can suppress reduction in modulus of elasticity at a high temperature, in addition to having a high glass transition temperature, even when a polyfunctional epoxy resin is blended thereinto.

### Means for Solving Problems

The present inventors have conducted diligent studies and consequently completed the present invention by finding that an epoxy resin composition that has completely uniform and sufficient filling properties and can suppress reduction in modulus of elasticity at a high temperature, in addition to having a markedly high glass transition temperature exceeding a curing temperature, when a polyfunctional epoxy resin is blended thereinto can be obtained by an epoxy resin composition containing a trifunctional or higher polyfunctional epoxy resin and an imidazole compound having a specific structure, wherein when a temperature T°C that satisfies 130 ≤ T ≤ 150 is kept constant, a slope α of a line satisfies 690 ≤ α ≤ 1000, the line being obtained by plotting Lnt (ordinate) against 1/T (abscissa) wherein a time for a viscosity to reach 10000 Pa·s based on a time when the temperature T°C has been attained is defined as t minute.

Specifically, the present invention is as follows.

[1] An epoxy resin composition comprising
   component (A): an epoxy resin, and
   component (B): a compound represented by the following formula (1) and/or a compound represented by the following formula (2), wherein
   the component (A) comprises at least one trifunctional or higher polyfunctional epoxy resin, and
   when a temperature T°C that satisfies 130 ≤ T ≤ 150 is kept constant, a slope α of a line satisfies 690 ≤ α ≤ 1000, the line being obtained by plotting Lnt (ordinate) against 1/T (abscissa) wherein a time for a viscosity to reach 10000 Pa·s based on a time when the temperature T°C has been attained is defined as t minute: 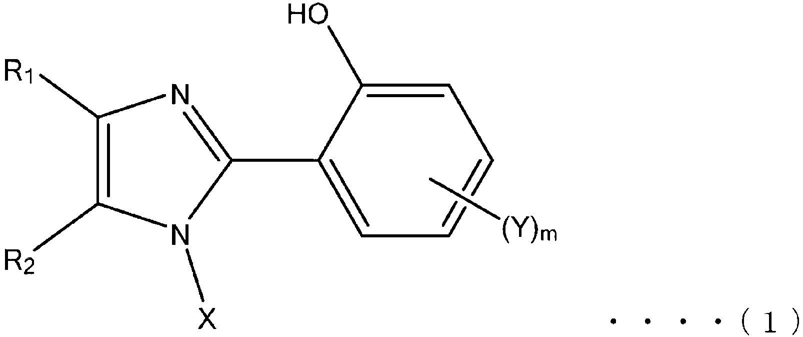 wherein
   R₁ and R₂ are each independently any one member selected from the group consisting of a hydrogen atom, a hydroxy group, a carboxy group, a cyano group, a nitro group, a halogen atom, an alkyl group having 1 to 20 carbon atoms and optionally having a substituent, and a cycloalkyl group having 6 to 20 carbon atoms and optionally having a substituent, R₁ and R₂ are the same as or different from each other, and R₁ and R₂ are optionally bonded to each other to form a condensed ring having no aromaticity;
   X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent;
   Y is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, a plurality of Y moieties, if present, are the same as or different from each other, and two or more Y moieties are optionally bonded to each other to form a monocyclic ring or a condensed ring; and m is an integer of 1 to 4, 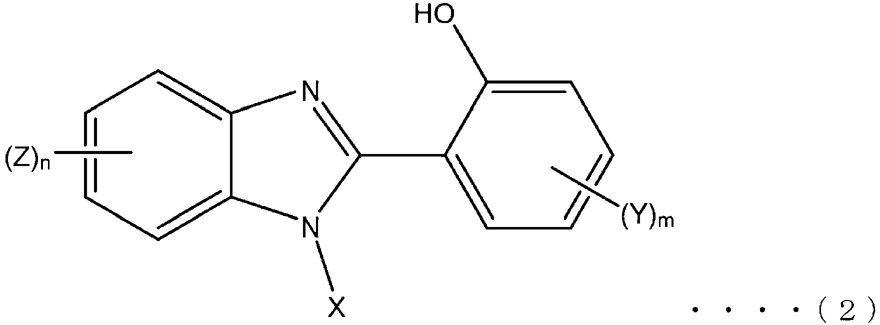 wherein
   X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent;
   each of Y and Z is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, Y and Z are the same as or different from each other, and two or more Y moieties or two or more Z moieties are optionally bonded to each other to form a monocyclic ring or a condensed ring; and m and n are each independently an integer of 1 to 4.
[2] The epoxy resin composition according to [1], wherein
   the component (A) further comprises a bifunctional or lower functional epoxy resin.
[3] The epoxy resin composition according to [2], wherein
   a blending ratio (mass ratio) between the trifunctional or higher polyfunctional epoxy resin and the bifunctional or lower functional epoxy resin is in a range of 1:0.1 to 1:10.
[4] The resin composition according to any of [1] to [3], wherein
   the component (A) comprises an epoxy resin having an aromatic ring.
[5] The resin composition according to any of [1] to [4], wherein
   the component (A) comprises an epoxy resin having no aromatic ring.
[6] The resin composition according to any of [1] to [5], wherein
   in the component (B),
   Y in the formula (1) is one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an alkoxy group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent, and
   each of Y and Z in the formula (2) is one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an alkoxy group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent.
[7] The epoxy resin composition according to any one of [1] to [5], wherein
   in the component (B),
   the compound represented by the formula (1) is any member selected from the group consisting of 2-(2-hydroxyphenyl)imidazole, 2-(2-hydroxyphenyl)-4(5)-methylimidazole, 4-ethyl-(2-hydroxyphenyl)-5-methylimidazole, (2-hydroxyphenyl)-4-isopropyl-5-methylimidazole, 4-butyl-(2-hydroxyphenyl)-5-methylimidazole, and 2-(2-hydroxy-3(5)-methoxyphenyl)imidazole,
      and/or
   the compound represented by the formula (2) is any member selected from the group consisting of 2-(2-hydroxyphenyl)benzimidazole, 2-(2-hydroxy-3(5)-methoxyphenyl)benzimidazole, 2-(1-hydroxynaphthalen-2-yl)benzimidazole, 2-(2-hydroxynaphthalen-1-yl)benzimidazole, and 2-(2-hydroxyphenyl)benzimidazole-6-carboxylic acid.
[8] The epoxy resin composition according to any one of [1] to [7], further comprising component (C): a filler.
[9] The resin composition according to any of [1] to [8], further comprising
   component (E): a thermoplastic resin.
[10] The resin composition according to any of [1] to [9], further comprising
   component (G): a silane coupling agent.
[11] The resin composition according to [10], wherein the component (G) is an aminosilane-based coupling agent.
[12] The resin composition according to any of [1] to [11], further comprising
   component (H): a non-epoxy group-terminated compound having a polyalkylene oxide structure.
[13] The epoxy resin composition according to [12], wherein
   the component (H) has a terminal hydroxy group.
[14] The epoxy resin composition according to [13], wherein
   the component (H) is a compound represented by the following formula (3): 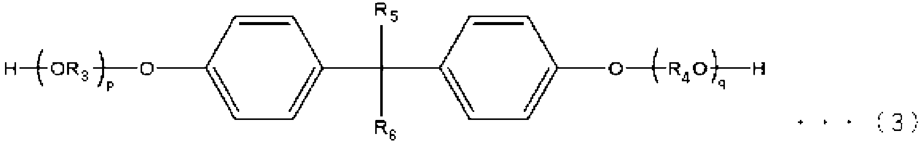 wherein R₃ and R₄ are each independently an alkyl group having 1 to 12 carbon atoms, and R₃ and R₄ are the same as or different from each other; p and q are each independently an integer of 1 or larger; and R₅ and R₆ are each independently one member selected from the group consisting of a hydrogen atom, an alkyl group having 1 to 20 carbon atoms and optionally having a substituent, a cycloalkyl group having 6 to 20 carbon atoms and optionally having a substituent, and an aryl group having 6 to 20 carbon atoms and optionally having a substituent, and R₅ and R₆ are the same as or different from each other.
[15] A resin paste comprising
   the epoxy resin composition according to any of [1] to [14].
[16] A resin film having
   a support, and
   a resin layer comprising the epoxy resin composition according to any of [1] to [14] on the support.
[17] The resin film according to [16], further having
   a protective layer.
[18] A cured product prepared by curing the epoxy resin composition according to any of [1] to [14].
[19] Semiconductor equipment having a layer of the cured product according to [18].

### Advantages of Invention

The present invention can provide an epoxy resin composition that has completely uniform and sufficient filling properties and can suppress reduction in modulus of elasticity at a high temperature, in addition to having a high glass transition temperature, even when a polyfunctional epoxy resin is blended thereinto.

### Mode for Carrying Out Invention

Hereinafter, the mode for carrying out the present invention (hereinafter, referred to as the "present embodiment") will be described in detail.

The present embodiment described below is given for illustrating the present invention and does not intend to limit the present invention to the contents given below. The present invention can be carried out through appropriate changes or modifications made without departing from the spirit of the present invention.

### [Epoxy resin composition]

The epoxy resin composition of the present embodiment comprises
component (A): an epoxy resin, and
component (B): a compound represented by the following formula (1) and/or a compound represented by the following formula (2), wherein
the component (A) comprises at least one trifunctional or higher polyfunctional epoxy resin, and
when a temperature T°C that satisfies 130 ≤ T ≤ 150 is kept constant, a slope α of a line satisfies 690 ≤ α ≤ 1000, the line being obtained by plotting Lnt (ordinate) against 1/T (abscissa) wherein a time for a viscosity to reach 10000 Pa·s based on a time when the temperature T°C has been attained is defined as t minute: 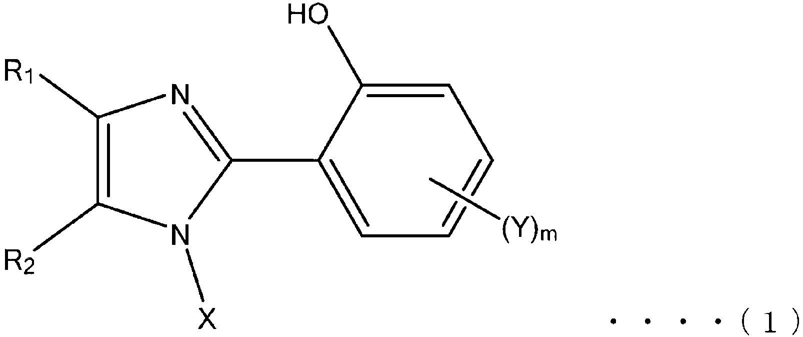 wherein
   R₁ and R₂ are each independently any one member selected from the group consisting of a hydrogen atom, a hydroxy group, a carboxy group, a cyano group, a nitro group, a halogen atom, an alkyl group having 1 to 20 carbon atoms and optionally having a substituent, and a cycloalkyl group having 6 to 20 carbon atoms and optionally having a substituent, R₁ and R₂ are the same as or different from each other, and R₁ and R₂ are optionally bonded to each other to form a condensed ring having no aromaticity;
   X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent;
   Y is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, a plurality of Y moieties, if present, are the same as or different from each other, and two or more Y moieties are optionally bonded to each other to form a monocyclic ring or a condensed ring; and m is an integer of 1 to 4, 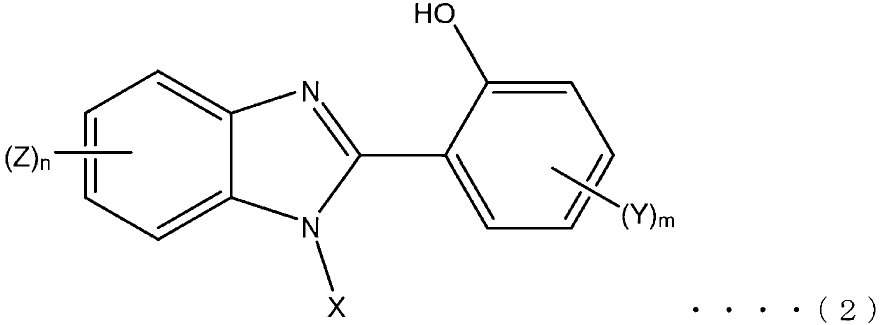 wherein
   X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent;
   each of Y and Z is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, Y and Z are the same as or different from each other, and two or more Y moieties or two or more Z moieties are optionally bonded to each other to form a monocyclic ring or a condensed ring; and m and n are each independently an integer of 1 to 4.

The epoxy resin composition of the present embodiment thus configured has completely uniform and sufficient filling properties and can suppress reduction in modulus of elasticity at a high temperature, in addition to having a high glass transition temperature, even when a polyfunctional epoxy resin is blended thereinto.

### (Component (A):epoxy resin)

The epoxy resin composition of the present embodiment comprises an epoxy resin (hereinafter, also referred to as an epoxy resin (A) or a component (A)), and the epoxy resin (A) comprises at least one trifunctional or higher polyfunctional epoxy resin.

In the epoxy resin (A), the trifunctional or higher polyfunctional epoxy resin is not particularly limited as long as the epoxy resin has three or more epoxy groups in one molecule. Examples thereof include: trifunctional epoxy resins such as trifunctional glycidyl amine-type epoxy resin (e.g., triglycidyl-p-aminophenol), triazine-type epoxy resin, trimethylolpropane triglycidyl ether, and glycerin triglycidyl ether; tetrafunctional epoxy resins such as naphthalene-type tetrafunctional epoxy resin, tetraglycidyl diaminodiphenylmethane-type epoxy resin, tetraglycidyl bis(aminomethyl)cyclohexane, diaminobenzene-type epoxy resin, and pentaerythritol-type epoxy resin; and polyfunctional epoxy resins such as phenol novolac-type epoxy resin, cresol novolac-type epoxy resin, biphenyl novolac-type epoxy resin, triphenylmethane-type epoxy resin, tetraphenylethane-type epoxy resin, dicyclopentadiene-type epoxy resin, naphthol novolac-type epoxy resin, and brominated phenol novolac-type epoxy resin. One of these epoxy resins may be used singly, or two or more thereof may be used in combination.

Among them, it is preferred for a resin paste to comprise a polyfunctional glycidyl amine-type epoxy resin such as triglycidyl-p-aminophenol, tetraglycidyl diaminodiphenylmethane-type epoxy resin, or tetraglycidyl bis(aminomethyl)cyclohexane, or pentaerythritol-type epoxy resin, from the viewpoint of attaining a high glass transition temperature and suppressing reduction in modulus of elasticity in a high-temperature region while maintaining fluidity, and obtaining sufficient strength.

It is preferred for a resin film to comprise polyfunctional glycidyl amine-type epoxy resin such as triglycidyl-p-aminophenol, tetraglycidyl diaminodiphenylmethane-type epoxy resin, or tetraglycidyl bis(aminomethyl)cyclohexane, pentaerythritol-type epoxy resin, naphthalene-type tetrafunctional epoxy resin, phenol novolac-type epoxy resin, cresol novolac-type epoxy resin, biphenyl novolac-type epoxy resin, triphenylmethane-type epoxy resin, tetraphenylethane-type epoxy resin, or pentaerythritol-type epoxy resin, from the viewpoint of attaining a high glass transition temperature, suppressing reduction in modulus of elasticity in a high-temperature region, and obtaining sufficient strength.

Specific examples of the trifunctional or higher polyfunctional epoxy resin include, but are not particularly limited to, trade names: HP-4700, HP-4710 (naphthalene-type tetrafunctional epoxy resin), N-690, N-695 (cresol novolac-type epoxy resin), HP-7200, HP-7200H, HP-7200HH (dicyclopentadiene-type epoxy resin), HP-6000, HP-6000L, EXA-7311, EXA-7311-G3, EXA-7311-G4, and EXA-7311-G4S (naphthylene ether-type epoxy resin) manufactured by DIC Corp., trade name: CNE220 (cresol novolac-type epoxy resin) manufactured by Chang Chun Plastics Co., Ltd., trade names: EPPN-502H (triphenylmethane-type epoxy resin), NC3000, NC3000H, NC3000L, NC3100 (biphenyl-type epoxy resin), and NC-7000L (naphthol novolac-type epoxy resin) manufactured by Nippon Kayaku Co., Ltd., trade names: ESN475V and ESN485 (naphthol-type epoxy resin), manufactured by Nippon Steel & Sumikin Chemical Co., Ltd., trade names: YX7700 (xylene structurecontaining novolac-type epoxy resin), jER1032S (triphenylmethane-type epoxy resin), jER1031S (tetraphenylethane-type epoxy resin), jER152 (phenol novolac-type epoxy resin), jER630, and jER630LSD (glycidyl amine-type epoxy resin) manufactured by Mitsubishi Chemical Group Corp., trade names: TETRAD-X and TETRAD-C (glycidyl amine-type epoxy resin) manufactured by Mitsubishi Gas Chemical Co., Inc., trade name: PETG (pentaerythritol-type epoxy resin) manufactured by Resonac Holdings Corp., trade name: EPOLEAD PB-3600 (epoxy resin having a butadiene structure) manufactured by Daicel Corp., and trade names: JP-100 and JP-200 (epoxy resin having a butadiene structure) manufactured by Nippon Soda Co., Ltd.

The epoxy resin (A) other than the trifunctional or higher polyfunctional epoxy resin is not particularly limited as long as the epoxy resin has two or less epoxy groups in one molecule. Examples thereof include bifunctional epoxy resins such as bisphenol A-type, bisphenol F-type, and bisphenol E-type epoxy resins, bisphenol AD-type epoxy resin, bisphenol AF-type epoxy resin, tetrabromobisphenol A-type epoxy resin, hydrogenated bisphenol A-type epoxy resin, glycidyl amine-type epoxy resin, silicone-modified epoxy resin, biphenyl-type epoxy resin, bixylenol-type epoxy resin, tetrabromobiphenyl-type epoxy resin, fluorene-type epoxy resin, diphenyl ether-type epoxy resin, benzophenone-type epoxy resin, phenyl benzoate-type epoxy resin, diphenyl sulfide-type epoxy resin, diphenyl sulfoxide-type epoxy resin, diphenylsulfone-type epoxy resin, diphenyl disulfide-type epoxy resin, naphthalene-type epoxy resin, anthracene-type epoxy resin, hydroquinone-type epoxy resin, methylhydroquinone-type epoxy resin, dibutylhydroquinone-type epoxy resin, resorcinol-type epoxy resin, methylresorcinol-type epoxy resin, catechol-type epoxy resin, glycidyl ester-type epoxy resin, and epoxy resins having a butadiene structure.

Further examples thereof include, but are not particularly limited to, epoxy resins that can be used as reactive diluents, such as N,N-diglycidyl aminobenzene, o-(N,N-diglycidyl amino)toluene, 2-ethyl hexyl glycidyl ether, cyclohexanedimethanol diglycidyl ether, neopentyl glycol diglycidyl ether, 1,6-hexanediol diglycidyl ether, butanediol diglycidyl ether, glycerin diglycidyl ether, cyclohexane-type diglycidyl ether, dicyclopentadiene-type diglycidyl ether, vinyl(3,4-cyclohexene) dioxide, 2-(3,4-epoxycyclohexyl)-5,1-spiro-(3,4-epoxycyclohexyl)-m-dioxane, 1,3-diglycidyl-5-methyl- 5-ethylhydantoin-type epoxy resin, 1,3-bis(3-glycidoxypropyl)-1,1,3,3-tetramethyldisiloxane-type epoxy resin, phenyl glycidyl ether, cresyl glycidyl ether, p-s-butyl phenyl glycidyl ether, styrene oxide, p-tert-butyl phenyl glycidyl ether, o-phenyl phenol glycidyl ether, p-phenyl phenol glycidyl ether, N-glycidyl phthalimide, n-butyl glycidyl ether, α-pinene oxide, allyl glycidyl ether, 1-vinyl-3,4-epoxycyclohexane, 1,2-epoxy-4-(2-methyloxiranyl)-1-methylcyclohexane, and neodecanoic acid glycidyl ester, and epoxy resins having a polyalkylene oxide structure, such as polyethylene glycol diglycidyl ether, polypropylene glycol diglycidyl ether, and polytetramethylene glycol diglycidyl ether.

One of these epoxy resins may be used singly, or two or more thereof may be used in combination.

It is preferred for a resin paste to comprise, as the epoxy resin (A) other than the trifunctional or higher polyfunctional epoxy resin described above, an epoxy resin having an aromatic ring, and it is more preferred to comprise bisphenol -type epoxy resin such as bisphenol A-type epoxy resin or bisphenol F-type epoxy resin, naphthalene-type epoxy resin, fluorene-type epoxy resin, p-tert-butyl phenyl glycidyl ether, N,N-diglycidyl aminobenzene, or o-(N,N-diglycidyl amino)toluene, from the viewpoint of fluidity and strength.

It is preferred to comprise an epoxy resin having no aromatic ring or an epoxy resin having a polyalkylene oxide structure, and it is more preferred to comprise hydrogenated bisphenol A-type epoxy resin, cyclohexane-type diglycidyl ether, dicyclopentadiene-type diglycidyl ether, or polytetramethylene glycol diglycidyl ether, when the amount of a filler blended is larger, when higher filling properties are intended, or from the viewpoint of reducing the warpage of a cured product.

It is preferred for a resin film to comprise, as the epoxy resin (A) other than the trifunctional or higher polyfunctional epoxy resin described above, an epoxy resin having an aromatic ring, and it is preferred to comprise a bifunctional epoxy resin having a bisphenol A-type structure, a bisphenol F-type structure, a bisphenol AF-type structure, a naphthalene structure, a fluorene structure, or a glycidyl amine structure, from the viewpoint of heat resistance and strength.

It is preferred to comprise a bifunctional epoxy resin having a cyclohexane structure, a cyclohexanedimethanol structure, a polyalkylene oxide structure, or a butadiene structure, or an alicyclic epoxy resin having an ester skeleton, from the viewpoint of being able to impart moderate tackiness, close contact, and flexibility to a film.

Specific examples of the epoxy resin (A) other than the trifunctional or higher polyfunctional epoxy resin include, but are not particularly limited to, trade names: EXA850CRP (BisA-type epoxy resin), EXA830CRP (BisF-type epoxy resin), HP4032, HP4032D, and HP4032SS (naphthalene-type epoxy resin) manufactured by DIC Corp., trade names: jER828US, jER828EL, jER825, YL980 (bisphenol A-type epoxy resin), jER807, jER1750, YL983U (bisphenol F-type epoxy resin), YX7400N (polytetramethylene glycol-type epoxy resin), YX4000, YX4000H, YX4000HS, YL6121 (biphenyl-type epoxy resin), YX4000HK (bixylenol-type epoxy resin), YX8800 (anthracene-type epoxy resin), and YX7760 (fluorine-containing special epoxy resin) manufactured by Mitsubishi Chemical Group Corp., trade names: ZX1059 (mixed product of bisphenol A-type epoxy resin and bisphenol F-type epoxy resin), ZX1658, and ZX1658GS (1,4-glycidyl cyclohexane-type liquid epoxy resin) manufactured by NIPPON STEEL Chemical & Material Co., Ltd., trade name: CDMDG (cyclohexanedimethanol diglycidyl ether) manufactured by Resonac Holdings Corp., trade names: GAN (N,N-diglycidyl aminobenzene) and GOT (o-(N,N-diglycidyl amino)toluene) manufactured by Nippon Kayaku Co., Ltd., trade name: BEO-60E (bisphenol A bis(triethylene glycol glycidyl ether) ether) manufactured by New Japan Chemical Co., Ltd., trade name: EX-721(glycidyl ester-type epoxy resin) manufactured by Nagase ChemteX Corp., trade names: CELLOXIDE 2021P (alicyclic epoxy resin having an ester skeleton) manufactured by Daicel Corp., trade names: OGSOL PG-100, CG-500, and EG-280 (fluorene-type epoxy resin) manufactured by Osaka Gas Chemicals Co., Ltd., trade name: EPOGOSEY PT (polytetramethylene glycol-type epoxy resin) manufactured by Yokkaichi Chemical Co., Ltd., and trade name: AER9000 (special modified epoxy resin) manufactured by Asahi Kasei Corp.

In the epoxy resin composition of the present embodiment, the epoxy resin (A) comprises at least one or more trifunctional or higher polyfunctional epoxy resins, which are preferably used in combination with a bifunctional or lower functional epoxy resin.

Such combined use for use in the form of a resin paste tends to have effects of, for example, (i) being able to rendering a viscosity moderately low so that handleability and filling properties are favorable, (ii) improving close contact with circuit components, and (iii) obtaining sufficient flexibility so that crack resistance is improved.

Such combined use for use in the form of a resin film tends to have effects of, for example, (iv) attaining favorable tackiness and close contact, (v) obtaining sufficient flexibility so that handleability is improved, and (vi) being able to obtain a cured product having a sufficient elongation.

In the case of using a trifunctional or higher functional epoxy resin and a bifunctional or lower functional epoxy resin in combination, their mass ratio (trifunctional or higher function epoxy resin: bifunctional or lower functional epoxy resin) is not particularly limited and is preferably in the range of 1:0.1 to 1:10, more preferably in the range of 1:0.2 to 1:9, further preferably in the range of 1:0.3 to 1:8, still further preferably in the range of 1:0.4 to 1:7, even further preferably in the range of 1:0.5 to 1:6, from the viewpoint of the effects (i) to (vi).

The epoxy equivalent of the trifunctional or higher functional epoxy resin is preferably 50 g/eq. to 500 g/eq., more preferably 50 g/eq. to 450 g/eq., further preferably 80 g/eq. to 400 g/eq., still further preferably 80 g/eq. to 350 g/eq., even further preferably 85 to 300 g/eq.

The epoxy equivalent of the trifunctional or higher functional epoxy resin falls within the above numeric range, whereby a cured product of the epoxy resin composition of the present embodiment upon combined use with the component (B) has a cross-link density in a proper range, and a cured product layer excellent in balance among the glass transition temperature of the cured product, the suppression of reduction in modulus of elasticity at a high temperature, and cured product strength tends to be obtained.

The epoxy equivalent of the bifunctional or lower functional epoxy resin is not particularly limited and can be appropriately set depending on desired performance. The epoxy equivalent is preferably 50 g/eq. to 5000 g/eq., more preferably 50 g/eq. to 3000 g/eq., further preferably 80 g/eq. to 2000 g/eq., still further preferably 100 g/eq. to 1000 g/eq., even further preferably 120 to 900 g/eq., from the viewpoint of attaining a cross-link density in a sufficient range upon combined use with the trifunctional or higher functional epoxy resin and attaining the balance among the elongation, toughness, and strength of a cured product.

The epoxy equivalent is the mass of a resin containing 1 equivalent of an epoxy group.

The epoxy equivalent can be measured in accordance with JIS K7236.

For the epoxy resin (A), the total chlorine content of the epoxy resin is preferably 2500 ppm or less, more preferably 2000 ppm or less, further preferably 1500 ppm or less, still further preferably 900 ppm or less, from the viewpoint of obtaining an epoxy resin composition excellent in balance between curability and storage stability while having excellent electric characteristics.

The total chlorine content of the epoxy resin (A) is preferably 0.01 ppm or more, more preferably 0.02 ppm or more, further preferably 0.05 ppm or more, still further preferably 0.1 ppm or more, even further preferably 0.2 ppm or more, particularly preferably 0.5 ppm or more, from the viewpoint of suppressing excessive reduction in chlorine content.

In this context, the total chlorine content refers to the total amount of organic chlorine and inorganic chlorine contained in the epoxy resin (A), and is a massbased value with respect to the epoxy resin (A).

The total chlorine content of the epoxy resin (A) is measured by the following method.

The epoxy resin (A) is repetitively washed and filtered using xylene until the epoxy resin is no longer found in the washing solution xylene. Next, the solvent in the filtrate is distilled off under reduced pressure at 100°C or lower to obtain an epoxy resin. 1 to 10 g of the obtained epoxy resin sample is precisely weighed such that a titer is 3 to 7 mL. This sample is dissolved in 25 mL of ethylene glycol monobutyl ether. To this solution, 25 mL of a solution of 1 N KOH in propylene glycol is added, and the mixture is boiled for 20 minutes, followed by titration with an aqueous silver nitrate solution. The total chlorine content is calculated from the titer.

The total content of the epoxy resin (A) including the trifunctional or higher functional epoxy resin and the bifunctional or lower functional epoxy resin in the epoxy resin composition of the present embodiment can be appropriately set depending on desired performance and is not particularly limited. The total content is preferably 5% by mass or more and 95% by mass or less, more preferably 10% by mass or more and 90% by mass or less, particularly preferably 15% by mass or more and 85% by mass or less, in all involatile components except for a solvent. The content of the epoxy resin falls within the range mentioned above, whereby the epoxy resin composition of the present embodiment tends to produce high adhesion.

(Component (B): compound represented by formula (1) or (2) given below)
The epoxy resin composition of the present embodiment comprises a compound represented by the following formula (1) and/or a compound represented by the following formula (2) (hereinafter, also referred to as a compound (B) or a component (B)): 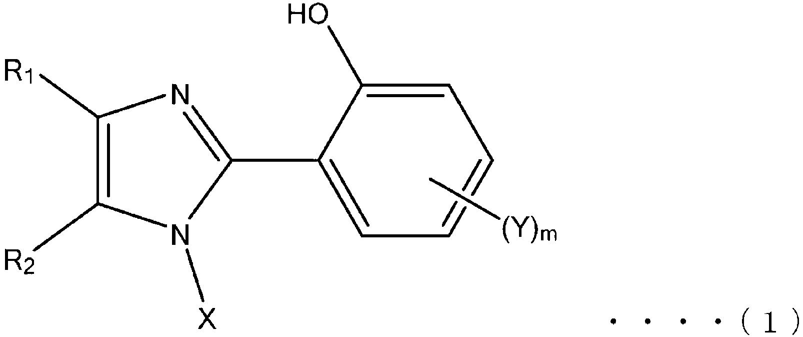 wherein
R₁ and R₂ are each independently any one member selected from the group consisting of a hydrogen atom, a hydroxy group, a carboxy group, a cyano group, a nitro group, a halogen atom, an alkyl group having 1 to 20 carbon atoms and optionally having a substituent, and a cycloalkyl group having 6 to 20 carbon atoms and optionally having a substituent, R₁ and R₂ are the same as or different from each other, and R₁ and R₂ are optionally bonded to each other to form a condensed ring having no aromaticity;
X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent;
Y is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, a plurality of Y moieties, if present, are the same as or different from each other, and two or more Y moieties are optionally bonded to each other to form a monocyclic ring or a condensed ring; and m is an integer of 1 to 4, 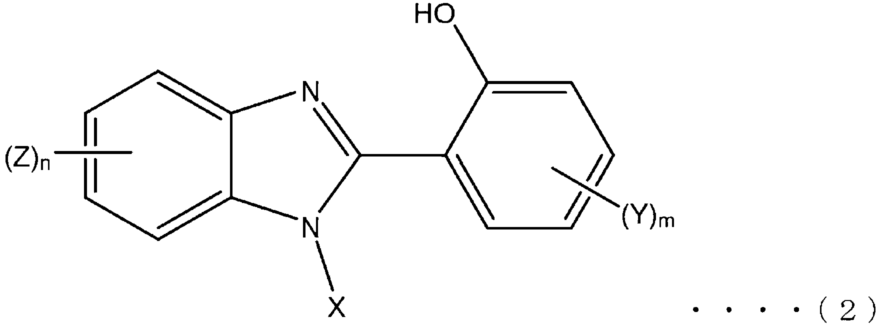 wherein
X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent;
each of Y and Z is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, Y and Z are the same as or different from each other, and two or more Y moieties or two or more Z moieties are optionally bonded to each other to form a monocyclic ring or a condensed ring; and m and n are each independently an integer of 1 to 4.

R₁ and R₂ in the general formula (1) are, as mentioned above, each independently one member selected from the group consisting of a hydrogen atom, a hydroxy group, a carboxy group, a cyano group, a nitro group, a halogen atom, an alkyl group having 1 to 20 carbon atoms and optionally having a substituent, and a cycloalkyl group having 6 to 20 carbon atoms and optionally having a substituent, or R₁ and R₂ have a structure on the same condensed ring having no aromaticity, and R₁ and R₂ are the same as or different from each other.

The alkyl group having 1 to 20 carbon atoms may be linear or branched, and the number of carbon atoms in the alkyl group is preferably 1 to 18, more preferably 1 to 15, further preferably 1 to 10. Examples of the alkyl group having 1 to 20 carbon atoms include, but are not particularly limited to, a methyl group, an ethyl group, an isopropyl group, a butyl group, an isobutyl group, a hexyl group, an octyl group, and a 2-ethylhexyl group.

The number of carbon atoms in the cycloalkyl group having 6 to 20 carbon atoms is preferably 6 to 18, more preferably 6 to 15. Examples of the cycloalkyl group having 6 to 20 carbon atoms include, but are not particularly limited to, a cyclohexyl group, a cycloheptyl group, and a cyclooctyl group.

Specific examples of the structure of R₁ and R₂ on the same condensed ring having no aromaticity include cyclopentane, cyclohexane, and dicyclopentadiene.

The alkyl group, the cycloalkyl group, and the structure of R₁ and R₂ on the same condensed ring having no aromaticity may each have a substituent. Examples of the substituent include, but are not particularly limited to, a halogen atom, a hydroxy group, an alkoxy group, and a nitro group. The substituent is preferably a hydroxy group or an alkoxy group.

X in the formulas (1) and (2) is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent.

The alkyl group having 1 to 20 carbon atoms as X may be linear or branched, and the number of carbon atoms in the alkyl group is preferably 1 to 18, more preferably 1 to 15. Examples of the alkyl group having 1 to 20 carbon atoms include, but are not particularly limited to, a methyl group, an ethyl group, an isopropyl group, a butyl group, an isobutyl group, a hexyl group, and an octyl group.

The alkenyl group having 2 to 20 carbon atoms as X may be linear or branched, and the number of carbon atoms in the alkenyl group is preferably 2 to 18, more preferably 2 to 15. Examples of the alkenyl group having 2 to 20 carbon atoms include, but are not particularly limited to, a vinyl group, an allyl group, a 1-propenyl group, an isopropenyl group, a 2-butenyl group, a 3-butenyl group, a 2-pentenyl group, and a 2-hexenyl group.

The aralkyl group having 7 to 20 carbon atoms as X may be linear or branched, and the number of carbon atoms in the aralkyl group is preferably 7 to 18, more preferably 7 to 15. Examples of the aralkyl group having 7 to 20 carbon atoms include, but are not particularly limited to, a benzyl group, a phenethyl group, and a naphthylmethyl group.

The heteroarylalkyl group having 4 to 20 carbon atoms as X may be linear or branched, and the number of carbon atoms in the heteroarylalkyl group is preferably 4 to 18, more preferably 4 to 15. Examples of the heteroarylalkyl group having 4 to 20 carbon atoms include, but are not particularly limited to, a triazinylmethyl group, a triazinylethyl group, a 2-pyridylmethyl group, a 2-pyridylethyl group, a 3-pyridylmethyl group, a 3-pyridylethyl group, a 4-pyridylmethyl group, and a 4-pyridylethyl group.

The alkyl group, the alkenyl group, the aralkyl group, or the heteroarylalkyl group may each have a substituent. Examples of the substituent include, but are not particularly limited to, a halogen atom, a cyano group, a nitro group, a hydroxy group, an alkoxy group, an amino group, an ester group, an arylsulfonyl group, an alkylsulfonyl group, and a phenyl group. The substituent is preferably a cyano group, an alkoxy group, an amino group, an ester group, or a phenyl group.

Each of Y in the general formula (1) and Y and Z in the general formula (2) is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent. In the general formula (1), two or more Y moieties are optionally bonded to each other to form a monocyclic ring or a condensed ring. In the general formula (2), two or more Y moieties or two or more Z moieties are optionally bonded to each other to form a monocyclic ring or a condensed ring. In the general formula (1), m is an integer of 1 to 4. In the general formula (2), m and n are each independently an integer of 1 to 4.

The alkyl group having 1 to 20 carbon atoms as Y or Z may be linear or branched, and the number of carbon atoms in the alkyl group is preferably 1 to 18, more preferably 1 to 15. Examples of the alkyl group having 1 to 20 carbon atoms include, but are not particularly limited to, a methyl group, an ethyl group, a propyl group, an isopropyl group, a butyl group, an isobutyl group, a hexyl group, an octyl group, a 2-ethylhexyl group, a decyl group, and an undecyl group.

The alkoxy group having 1 to 20 carbon atoms as Y or Z may be linear or branched, and the number of carbon atoms is preferably 1 to 18, more preferably 1 to 15. Examples of the alkoxy group having 1 to 20 carbon atoms include, but are not particularly limited to, a methoxy group, an ethoxy group, a propoxy group, an isopropoxy group, a butoxy group, a hexyloxy group, and a 2-ethylhexyloxy group.

The alkenyl group having 2 to 20 carbon atoms as Y or Z may be linear or branched, and the number of carbon atoms in the alkenyl group is preferably 2 to 18, more preferably 2 to 15. Examples of the alkenyl group having 2 to 20 carbon atoms include, but are not particularly limited to, a vinyl group, an allyl group, a 1-propenyl group, an isopropenyl group, a 2-butenyl group, a 3-butenyl group, a 2-pentenyl group, and a 2-hexenyl group.

The number of carbon atoms in the aryl group having 6 to 20 carbon atoms as Y or Z is preferably 6 to 18, more preferably 6 to 15. Examples of the aryl group having 6 to 20 carbon atoms include, but are not particularly limited to, a phenyl group, a naphthyl group, an anthracenyl group, and a biphenyl group.

Examples of the structure where two or more Y moieties or two or more Z moieties are bonded to each other to form a monocyclic ring or a condensed ring include, but are not particularly limited to, a naphthyl group and an anthracenyl group.

The number of carbon atoms in the acyl group having 1 to 20 carbon atoms as Y or Z is preferably 1 to 18, more preferably 1 to 15. Examples of the acyl group having 1 to 20 carbon atoms include, but are not particularly limited to, an acetyl group, a benzoyl group, and a pivaloyl group.

The alkyl group, the alkoxy group, the alkenyl group, the aryl group, the aryloxy group, and the acyl group may each have a substituent. Examples of the substituent include an alkyl group, a halogen atom, a hydroxy group, a carboxy group, an alkoxy group, a nitro group, an ester group, and a phenyl group. The substituent is preferably an alkyl group, a hydroxy group, a carboxy group, or an alkoxy group.

Y may be substituted at any of the ortho, meta, and para positions of the substituent phenyl group at position 2 of imidazole and, in the case of having a substituent, is preferably substituted at a position other than the ortho position, preferably substituted at least at the meta position, and more preferably substituted at the meta position by a hydroxy group or an alkoxy group having 1 to 20 carbon atoms and optionally having a substituent.

Among those described above, Y in the formula (1) is more preferably one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an alkoxy group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent.

Each of Y and Z in the general formula (2) is more preferably one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an alkoxy group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, an acyl group having 1 to 20 carbon atoms and having a hydroxy group and/or a carboxy group as a substituent.

Each of Y and Z is a hydrogen atom, whereby a cured product obtained using the epoxy resin composition of the present embodiment can have a lower dielectric dissipation factor.

When each of Y and Z is a hydroxy group, a carboxy group, an alkoxy group having 1 to 20 carbon atoms and having no substituent, an alkyl group having 1 to 20 carbon atoms and having a hydroxy group and/or a carboxy group as a substituent, an alkoxy group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, or an acyl group having 1 to 20 carbon atoms and having a hydroxy group and/or a carboxy group as a substituent, coordination bondability to an adherend such as a metal is increased: thus, close contact and adhesion strength tend to be able to be improved.

Examples of the compound represented by the general formula (1) include, but are not limited to, the following imidazole compounds:
2-(2-hydroxyphenyl)imidazole, 2-(2-hydroxyphenyl)-4(5)-methylimidazole, 4(5)-ethyl-2-(2-hydroxyphenyl)imidazole, 4,5-dimethyl-2-(2-hydroxyphenyl)imidazole, 4-ethyl-(2-hydroxyphenyl)-5-methylimidazole, (2-hydroxyphenyl)-4-isopropyl-5-methylimidazole, 4-butyl-(2-hydroxyphenyl)-5-methylimidazole, 2-(2-hydroxy-3-methylphenyl)imidazole, 2-(2-hydroxy-3-methylphenyl)-4(5)-methylimidazole, 4(5)-ethyl-2-(2-hydroxy-3-methylphenyl)imidazole, 4,5-dimethyl-2-(2-hydroxy-3-methylphenyl)imidazole, 4-ethyl-(2-hydroxy-3-methylphenyl)-5-methylimidazole, (2-hydroxy-3-methylphenyl)-4-isopropyl-5-methylimidazole, 4-butyl-(2-hydroxy-3-methylphenyl)-5-methylimidazole, 2-(2-hydroxy-4-methylphenyl)imidazole, 2-(2-hydroxy-4-methylphenyl)-4(5)-methylimidazole, and 4(5)-ethyl-2-(2-hydroxy-4-methylphenyl)imidazole.

Other examples thereof include 4,5-dimethyl-2-(2-hydroxy-4-methylphenyl)imidazole, 4-ethyl-(2-hydroxy-4-methylphenyl)-5-methylimidazole, (2-hydroxy-4-methylphenyl)-4-isopropyl-5-methylimidazole, 4-butyl-(2-hydroxy-4-methylphenyl)-5-methylimidazole, 2-(2-hydroxy-5-methylphenyl)imidazole, 2-(2-hydroxy-5-methylphenyl)-4(5)-methylimidazole, 4(5)-ethyl-2-(2-hydroxy-5-methylphenyl)imidazole, 4,5-dimethyl-2-(2-hydroxy-5-methylphenyl)imidazole, 4-ethyl-(2-hydroxy-5-methylphenyl)-5-methylimidazole, (2-hydroxy-5-methylphenyl)-4-isopropyl-5-methylimidazole, 4-butyl-(2-hydroxy-5-methylphenyl)-5-methylimidazole, 2-(3-t-butyl-2-hydroxyphenyl)imidazole, 2-(3-t-butyl-2-hydroxyphenyl)-4(5)-methylimidazole, and 2-(3-t-butyl-2-hydroxyphenyl)-4(5)-ethylimidazole.

Further examples thereof include 2-(3-t-butyl-2-hydroxyphenyl)-4,5-dimethylimidazole, 2-(3-t-butyl-2-hydroxyphenyl)-4-ethyl-5-methylimidazole, 2-(3-t-butyl-2-hydroxyphenyl)-4-isopropyl-5-methylimidazole, 4-butyl-2-(3-t-butyl-2-hydroxyphenyl)-5-methylimidazole, 2-(4-fluoro-2-hydroxyphenyl)imidazole, 2-(4-fluoro-2-hydroxyphenyl)-4(5)-methylimidazole, 2-(4-fluoro-2-hydroxyphenyl)-4(5)-ethylimidazole, 2-(4-fluoro-2-hydroxyphenyl)-4,5-dimethylimidazole, 4-ethyl-2-(4-fluoro-2-hydroxyphenyl)-5-methylimidazole, 2-(4-fluoro-2-hydroxyphenyl)-4-isopropyl-5-methylimidazole, 4-butyl-2-(4-fluoro-2-hydroxyphenyl)-5-methylimidazole, 2-(4-chloro-2-hydroxyphenyl)imidazole, 2-(4-chloro-2-hydroxyphenyl)-4(5)-methylimidazole, and 2-(4-chloro-2-hydroxyphenyl)-4(5)-ethylimidazole.

Further examples thereof include 2-(4-chloro-2-hydroxyphenyl)-4,5-dimethylimidazole, 2-(4-chloro-2-hydroxyphenyl)-4-ethyl-5-methylimidazole, 2-(4-chloro-2-hydroxyphenyl)-4-isopropyl-5-methylimidazole, 4-butyl-2-(4-chloro-2-hydroxyphenyl)-5-methylimidazole, 2-(4-bromo-2-hydroxyphenyl)imidazole, 2-(4-bromo-2-hydroxyphenyl)-4(5)-methylimidazole, 2-(4-bromo-2-hydroxyphenyl)-4(5)-ethylimidazole, 2-(4-bromo-2-hydroxyphenyl)-4,5-dimethylimidazole, 2-(4-bromo-2-hydroxyphenyl)-4-ethyl-5-methylimidazole, 2-(4-bromo-2-hydroxyphenyl)-4-isopropyl-5-methylimidazole, 2-(4-bromo-2-hydroxyphenyl)-4-butyl-5-methylimidazole, and 2-(2,3-dihydroxyphenyl)imidazole.

Further examples thereof include 2-(2,3-dihydroxyphenyl)-4(5)-methylimidazole, 2-(2,3-dihydroxyphenyl)-4(5)-ethylimidazole, 2-(2,3-dihydroxyphenyl)-4,5-dimethylimidazole, 2-(2,3-dihydroxyphenyl)-4(5)-phenylimidazole, 2-(2,3-dihydroxyphenyl)-4,5-diphenylimidazole, 2-(2,5-dihydroxyphenyl)imidazole, 2-(2,5-dihydroxyphenyl)-4(5)-methylimidazole, 2-(2,5-dihydroxyphenyl)-4(5)-ethylimidazole, 2-(2,5-dihydroxyphenyl)-4,5-dimethylimidazole, 2-(2,5-dihydroxyphenyl)-4(5)-phenylimidazole, 2-(2,5-dihydroxyphenyl)-4,5-diphenylimidazole, 2-(2-hydroxy-4-methoxyphenyl)imidazole, 2-(2-hydroxy-4-methoxyphenyl)-4(5)-methylimidazole, 4(5)-ethyl-2-(2-hydroxy-4-methoxyphenyl)imidazole, 4,5-dimethyl-2-(2-hydroxy-4-methoxyphenyl)imidazole, 2-(2-hydroxy-4-methoxyphenyl)-4(5)-phenylimidazole, 4,5-diphenyl-2-(2-hydroxy-4-methoxyphenyl)imidazole, 2-(2-hydroxy-3-methoxyphenyl)imidazole, 2-(2-hydroxy-3-methoxyphenyl)-4(5)-methylimidazole, and 4(5)-ethyl-2-(2-hydroxy-3-methoxyphenyl)imidazole.

Further examples thereof include 4,5-dimethyl-2-(2-hydroxy-3-methoxyphenyl)imidazole, 2-(2-hydroxy-3-methoxyphenyl)-4(5)-phenylimidazole, 4,5-diphenyl-2-(2-hydroxy-3-methoxyphenyl)imidazole, 2-(2-hydroxy-5-methoxyphenyl)imidazole, 2-(2-hydroxy-5-methoxyphenyl)-4(5)-methylimidazole, 4(5)-ethyl-2-(2-hydroxy-5-methoxyphenyl)imidazole, 4,5-dimethyl-2-(2-hydroxy-5-methoxyphenyl)imidazole, 2-(2-hydroxy-5-methoxyphenyl)-4(5)-phenylimidazole, 4,5-diphenyl-2-(2-hydroxy-5-methoxyphenyl)imidazole, 2-(2-hydroxy-6-methoxyphenyl)imidazole, 2-(2-hydroxy-6-methoxyphenyl)-4(5)-methylimidazole, 4(5)-ethyl-2-(2-hydroxy-6-methoxyphenyl)imidazole, 4,5-dimethyl-2-(2-hydroxy-6-methoxyphenyl)imidazole, 2-(2-hydroxy-6-methoxyphenyl)-4(5)-phenylimidazole, 4,5-diphenyl-2-(2-hydroxy-6-methoxyphenyl)imidazole, 2-(3-ethoxy-2-hydroxyphenyl)imidazole, 2-(3-ethoxy-2-hydroxyphenyl)-4(5)-methylimidazole, 2-(3-ethoxy-2-hydroxyphenyl)-4(5)-ethylimidazole, 4,5-dimethyl-2-(3-ethoxy-2-hydroxyphenyl)imidazole, and 2-(3-ethoxy-2-hydroxyphenyl)-4(5)-phenylimidazole.

Further examples thereof include 4,5-diphenyl-2-(3-ethoxy-2-hydroxyphenyl)imidazole, 2-(5-ethoxy-2-hydroxyphenyl)imidazole, 2-(5-ethoxy-2-hydroxyphenyl)-4(5)-methylimidazole, 2-(5-ethoxy-2-hydroxyphenyl)-4(5)-ethylimidazole, 4,5-dimethyl-2-(5-ethoxy-2-hydroxyphenyl)imidazole, 2-(5-ethoxy-2-hydroxyphenyl)-4(5)-phenylimidazole, 4,5-diphenyl-2-(5-ethoxy-2-hydroxyphenyl)imidazole, 2-(4-allyl-2-hydroxy-3-methoxyphenyl)imidazole, 2-(4-allyl-2-hydroxy-3-methoxyphenyl)-4(5)-methylimidazole, 2-(4-allyl-2-hydroxy-3-methoxyphenyl)-4(5)-ethylimidazole, 2-(4-allyl-2-hydroxy-3-methoxyphenyl)-4,5-dimethylimidazole, 2-(4-allyl-2-hydroxy-3-methoxyphenyl)-4(5)-phenylimidazole, 2-(4-allyl-2-hydroxy-3-methoxyphenyl)-4,5-diphenylimidazole, and 2-(4,6-dimethoxy-2-hydroxyphenyl)imidazole.

Further examples thereof include 2-(4,6-dimethoxy-2-hydroxyphenyl)-4(5)-methylimidazole, 2-(4,6-dimethoxy-2-hydroxyphenyl)-4(5)-ethylimidazole, 2-(4,6-dimethoxy-2-hydroxyphenyl)-4,5-dimethylimidazole, 2-(4,6-dimethoxy-2-hydroxyphenyl)-4(5)-phenylimidazole, 2-(4,6-dimethoxy-2-hydroxyphenyl)-4,5-diphenylimidazole, 2-(2-fluoro-5-hydroxyphenyl)imidazole, 2-(2-fluoro-5-hydroxyphenyl)-4(5)-methylimidazole, 2-(2-fluoro-5-hydroxyphenyl)-4(5)-ethylimidazole, 2-(2-fluoro-5-hydroxyphenyl)-4,5-dimethylimidazole, 2-(2-fluoro-5-hydroxyphenyl)-4(5)-phenylimidazole, 2-(2-fluoro-5-hydroxyphenyl)-4,5-diphenylimidazole, 2-(5-fluoro-2-hydroxyphenyl)imidazole, 2-(5-fluoro-2-hydroxyphenyl)-4(5)-methylimidazole, and 2-(5-fluoro-2-hydroxyphenyl)-4(5)-ethylimidazole.

Further examples thereof include 2-(5-fluoro-2-hydroxyphenyl)-4,5-dimethylimidazole, 2-(5-fluoro-2-hydroxyphenyl)-4(5)-phenylimidazole, 2-(5-fluoro-2-hydroxyphenyl)-4,5-diphenylimidazole, 2-(5-chloro-2-hydroxyphenyl)imidazole, 2-(5-chloro-2-hydroxyphenyl)-4(5)-methylimidazole, 2-(5-chloro-2-hydroxyphenyl)-4(5)-ethylimidazole, 2-(5-chloro-2-hydroxyphenyl)-4,5-dimethylimidazole, 2-(5-chloro-2-hydroxyphenyl)-4(5)-phenylimidazole, 2-(5-chloro-2-hydroxyphenyl)-4,5-diphenylimidazole, 2-(5-bromo-2-hydroxyphenyl)imidazole, 2-(5-bromo-2-hydroxyphenyl)-4(5)-methylimidazole, 2-(5-bromo-2-hydroxyphenyl)-4(5)-ethylimidazole, 2-(5-bromo-2-hydroxyphenyl)-4,5-dimethylimidazole, 2-(5-bromo-2-hydroxyphenyl)-4(5)-phenylimidazole, 2-(5-bromo-2-hydroxyphenyl)-4,5-diphenylimidazole, and 2-(6-fluoro-2-hydroxy-3-methoxyphenyl)imidazole.

Further examples thereof include 2-(6-fluoro-2-hydroxy-3-methoxyphenyl)-4(5)-methylimidazole, 2-(6-fluoro-2-hydroxy-3-methoxyphenyl)-4(5)-ethylimidazole, 2-(6-fluoro-2-hydroxy-3-methoxyphenyl)-4,5-dimethylimidazole, 2-(6-fluoro-2-hydroxy-3-methoxyphenyl)-4(5)-phenylimidazole, 2-(6-fluoro-2-hydroxy-3-methoxyphenyl)-4,5-diphenylimidazole, 2-(1-hydroxynaphthalen-2-yl)imidazole, 2-(1-hydroxynaphthalen-2-yl)-4(5)-methylimidazole, 2-(1-hydroxynaphthalen-2-yl)-4(5)-ethylimidazole, 4,5-dimethyl-2-(1-hydroxynaphthalen-2-yl)imidazole, 2-(1-hydroxynaphthalen-2-yl)-4(5)-phenylimidazole, 4,5-diphenyl-2-(1-hydroxynaphthalen-2-yl)imidazole, 2-(2-hydroxynaphthalen-1-yl)imidazole, 2-(2-hydroxynaphthalen-1-yl)-4(5)-methylimidazole, 2-(2-hydroxynaphthalen-1-yl)-4(5)-ethylimidazole, 4,5-dimethyl-2-(2-hydroxynaphthalen-1-yl)imidazole, 2-(2-hydroxynaphthalen-1-yl)-4(5)-phenylimidazole, and 4,5-diphenyl-2-(2-hydroxynaphthalen-1-yl)imidazole.

Examples of the compound represented by the general formula (2) include, but are not limited to, the following imidazole compounds:
2-(2-hydroxyphenyl)benzimidazole, 2-(2-hydroxy-3-methylphenyl)benzimidazole, 2-(2-hydroxy-4-methylphenyl)benzimidazole, 2-(2-hydroxy-5-methylphenyl)benzimidazole, 2-(3-t-butyl-2-hydroxyphenyl)benzimidazole, 2-(4-fluoro-2-hydroxyphenyl)benzimidazole, 2-(4-chloro-2-hydroxyphenyl)benzimidazole, 2-(4-bromo-2-hydroxyphenyl)benzimidazole, 2-(2,3-dihydroxyphenyl)benzimidazole, 2-(2,5-dihydroxyphenyl)benzimidazole, 2-(2-hydroxy-4-methoxyphenyl)benzimidazole, 2-(2-hydroxy-3-methoxyphenyl)benzimidazole, 2-(2-hydroxy-5-methoxyphenyl)benzimidazole, 2-(2-hydroxy-6-methoxyphenyl)benzimidazole, 2-(3-ethoxy-2-hydroxyphenyl)benzimidazole, 2-(5-ethoxy-2-hydroxyphenyl)benzimidazole, 2-(4-allyl-2-hydroxy-3-methoxyphenyl)benzimidazole, 2-(4,6-dimethoxy-2-hydroxyphenyl)benzimidazole, 2-(5-fluoro-2-hydroxyphenyl)benzimidazole, 2-(5-chloro-2-hydroxyphenyl)benzimidazole, 2-(5-bromo-2-hydroxyphenyl)benzimidazole, 2-(6-fluoro-2-hydroxy-3-methoxyphenyl)benzimidazole, 2-(1-hydroxynaphthalen-2-yl)benzimidazole, 2-(2-hydroxynaphthalen-1-yl)benzimidazole, and 2-(2-hydroxyphenyl)benzimidazole-6-carboxylic acid.

Among them, the compound represented by the general formula (1) is preferably a compound in which both R₁ and R₂ are hydrogen atoms or have different substituents, more preferably, for example, 2-(2-hydroxyphenyl)imidazole, 2-(2-hydroxyphenyl)-4(5)-methylimidazole, 4-ethyl-(2-hydroxyphenyl)-5-methylimidazole, (2-hydroxyphenyl)-4-isopropyl-5-methylimidazole, 4-butyl-(2-hydroxyphenyl)-5-methylimidazole, or 2-(2-hydroxy-3(5)-methoxyphenyl)imidazole, further preferably 2-(2-hydroxyphenyl)imidazole, from the viewpoint of obtaining a homogenous epoxy resin composition owing to excellent solubility in the epoxy resin (A) or a solvent, attaining a high glass transition temperature of a cured product, and suppressing reduction in modulus of elasticity in a high-temperature region.

The compound represented by the general formula (2) is preferably 2-(2-hydroxyphenyl)benzimidazole, 2-(2-hydroxy-3(5)-methoxyphenyl)benzimidazole, 2-(1-hydroxynaphthalen-2-yl)benzimidazole, 2-(2-hydroxynaphthalen-1-yl)benzimidazole, or 2-(2-hydroxyphenyl)benzimidazole-6-carboxylic acid, more preferably 2-(2-hydroxyphenyl)benzimidazole or 2-(2-hydroxy-3(5)-methoxyphenyl)benzimidazole, from the viewpoint of obtaining similar effects.

The component (B) has a structural feature of an imidazole structure that reacts with an epoxy group, the structure being substituted at position 2 of imidazole by a hydroxyphenyl group. Hence, the component (B) is excellent in compatibility with resins having an aromatic ring or polar solvents and can be favorably dissolved in various epoxy resins or solvents.

As for the achievement of stability and curability, the formation of an intramolecular hydrogen bond between a reactive site nitrogen and its adjacent hydroxyphenyl group in imidazole, as described in Patent Document 4, suppresses the nucleophilicity of nitrogen on imidazole at the time of storage, leading to stability, whereas the hydrogen bond is dissociated at the time of heating, leading to reaction.

In general, solid dispersion-type imidazole compounds having reduced compatibility with an epoxy resin are known as highly stable imidazole compounds. However, such imidazole compounds might reduce uniform curability because of being solid. Other concerns thereof are that, particularly, in the case of performing the step of filling a resin paste into narrow space, filling properties might be reduced due to clogging, or in the case of performing the step of adding a solvent and preparing a thin film, as in resin films, film formability is reduced due to particle residues; these compounds cannot be applied to ultrathin films; and even the solid dispersion-type compounds cannot produce stability by dissolution depending on the type of a solvent, for example.

Thus, the component (B) for use in the epoxy resin composition of the present embodiment, which can achieve stability and reactivity while uniformly dissolved in resins or solvents, is suitable, particularly, for purposes such as resin pastes for use in filling into narrow space or resin films prepared as thin films using solvents.

The epoxy resin composition of the present embodiment comprises the component (B) as a catalyst, whereby, surprisingly, a markedly high glass transition temperature exceeding a curing temperature is conferred when a polyfunctional epoxy resin is blended thereinto, and reduction in modulus of elasticity at a high temperature can be suppressed. Such an effect cannot be readily predicted from the structure of the component (B). The present inventors have further studied effects of imidazole compounds having various structures in a course leading to the present invention, and found that a compound that, among curing agents or curing accelerators that can be dissolved in a resin or a solvent for complete homogeneity, a compound that can confer a glass transition temperature exceeding a curing temperature and markedly suppress reduction in modulus of elasticity at a high temperature is only the component (B) contained, and the combination of the component (B) with a polyfunctional epoxy resin is exceedingly useful for obtaining the effect.

The present inventors presume the mechanism under which the effect is obtained only in combined use of the component (B), but not intended to be limited to, as follows.

In general, if a curing temperature is lower than the glass transition temperature of high-molecular-weight products formed through reaction, most of the high-molecular-weight products are no longer mobile in a glass state and largely reduce reaction efficiency; thus, unreacted monomers easily remain. Thus, a glass transition temperature equal to or higher than a curing temperature is exceedingly difficult to obtain. Particularly, in the case of using a polyfunctional epoxy resin, cross-linking progresses rapidly due to a high functional group density and facilitates locally forming high-molecular-weight products having a high glass transition temperature. This largely reduces the mobility of molecular chains and tends to reduce reaction efficiency. In addition, thickening associated with rapid increase in molecular weight also reduces the diffusivity of various curing agents or accelerators. Therefore, the functional group of an epoxy resin or a curing agent is insufficiently reacted, or nonuniform curing occurs due to local thickening. Thus, a sufficient cross-link density tends to be difficult to obtain. As a result, problems of conventional techniques are a lower glass transition temperature than expected and marked reduction in modulus of elasticity at a high temperature, even if a polyfunctional epoxy resin is used.

A low stable curing agent or curing accelerator causes more rapid thickening. Therefore, the problems described above are more conspicuous. Use of a highly stable solid dispersion-type curing agent or curing accelerator can suppress thickening, whereas components of the curing agent or the curing accelerator are insufficiently diffused when the diffusivity of various components is reduced as reaction progresses. As a result, these components remain as solids in the composition and tend to be nonuniformly cured.

On the other hand, in the case of using the component (B), the component (B) is considered to play a role as a chain transfer agent derived from its structural feature such that a proton for stabilization is donated to an anion formed in ring opening through the reaction of an epoxy group with imidazole, by a hydroxyphenyl group located close thereto. This suppresses acute formation of high-molecular-weight products and thickening during polymerization reaction and can cause chain extension reaction throughout the system. Thus, even in the case of using a polyfunctional epoxy resin, thickening during curing can occur mildly and uniformly so that a cured layer having a high cross-link density and a high glass transition temperature with its modulus of elasticity hardly reduced even at a high temperature is obtained because unreacted epoxy groups are unlikely to remain.

A hydroxyphenyl group in the component (B) is considered to form a bond through addition reaction with an epoxy group. In general, when a compound that is not involved in a bond remains in a polymer, this compound is responsible for weakening intermolecular force between polymer chains and decreasing a glass transition temperature. Nonetheless, the component (B) is incorporated through a bond into a cross-linked structure and therefore, does not decrease a glass transition temperature. Furthermore, the component (B) has an aromatic ring and therefore exerts a stacking effect with an epoxy resin also rich in aromatic ring and causes stronger intermolecular force between polymer chains. Therefore, the glass transition temperature is more improved, and reduction in modulus of elasticity in a high-temperature region can be more suppressed.

In light of the mechanism mentioned above, a wide range of components (B) having a structural feature represented by the general formula (1) and/or (2), including those having various substitutions of functional groups, produce the advantageous effects of the present invention by use in combination with a trifunctional or higher polyfunctional epoxy resin.

In the epoxy resin composition of the present embodiment, the mass ratio between the trifunctional or higher polyfunctional epoxy resin and the component (B) is not particularly limited and can be appropriately set on the basis of curing conditions, a desired reaction rate, and performance. The mass ratio of involatile components except for a solvent with the trifunctional or higher polyfunctional epoxy resin defined as 100 is preferably 100:0.001 to 100:20, more preferably 100:0.005 to 100:15, further preferably 100:0.005 to 100:10, still further preferably 100:0.01 to 100:5, even further preferably 100:0.015 to 100:4, particularly preferably 100:0.02 to 100:3.

Within this range, the ability to cure the polyfunctional epoxy resin by the component (B) can be obtained within right ranges, and curability is favorable. Therefore, uniform curing can be attained, and storage stability tends to be favorable.

The content of the component (B) in the whole epoxy resin composition of the present embodiment is not particularly limited and is preferably 0.001% by mass or more, more preferably 0.01% by mass or more, further preferably 0.02% by mass or more, still further preferably 0.04% by mass or more, even further preferably 0.05% by mass or more, in all involatile components except for a solvent from the viewpoint of obtaining sufficient curability. The content is preferably 40% by mass or less, more preferably 30% by mass or less, further preferably 20% by mass or less, still further preferably 15% by mass or less, even further preferably 10% by mass or less, from the viewpoint of keeping a curing rate proper and maintaining the homogeneity of a cured product layer. However, the component (B) catalytically reacts with the component (A), i.e., the epoxy resin. Therefore, those skilled in the art can set a proper amount in consideration of the material or composition used and desired performance.

### (Reaction sensitivity parameter α of epoxy resin composition)

In the epoxy resin composition of the present embodiment, when a temperature T°C that satisfies 130 ≤ T ≤ 150 is kept constant, a slope α of a line (hereinafter, also referred to as a parameter α) satisfies 690 ≤ α ≤ 1000, the line being obtained by plotting Lnt (ordinate) against 1/T (abscissa) wherein a time for a viscosity to reach 10000 Pa·s based on a time when the temperature T°C has been attained is defined as t minute.

In the present embodiment, the parameter α is calculated as follows.

At least two or more temperatures T°C that satisfy 130 ≤ T ≤ 150 are selected, and the viscosity of the epoxy resin composition is measured over time at each selected temperature kept constant under an oscillation (f = 1 Hz) condition using a rheometer. The time t minute for the viscosity to reach 10000 Pa·s based on a time when the temperature T°C has been attained is measured.

Next, 1/T is assigned to the abscissa, and Ln (natural logarithm) t is assigned to the ordinate. The value of Lnt against 1/T obtained as described above is plotted. Then, an approximate line is created by a least squares method for plotted data points, and α can be determined as the slope of the line.

For example, HAAKE MARS manufactured by Thermo Fisher Scientific Inc. can be used as the rheometer.

The parameter α varies depending on the type or amount of the epoxy resin or a curing agent. When the parameter α satisfies 690 ≤ α ≤ 1000, the epoxy resin composition has favorable filling properties and can achieve both of a high glass transition temperature and the suppression of reduction in modulus of elasticity at a high temperature after curing.

The present inventors presume the mechanism under which the effect is obtained when the parameter α falls within the above range, but not intended to be limited to, as follows.

The parameter α is a parameter dependent on the time to reach a gel state with a viscosity as high as 10000 Pa·s at a predetermined temperature, and is considered to indicate reaction sensitivity when the epoxy resin composition is heated. For example, a smaller value taken by the parameter α presumably indicates that the epoxy resin composition has smaller reaction sensitivity against a heating temperature, i.e., smaller change in reactivity dependent on a temperature. When the parameter α is 690 or more, the epoxy resin composition can maintain filling properties by suppressing thickening, for example, in a temperature zone of 130°C or lower, and is sufficiently cured by having sufficient reactivity when heated. Thus, a desired glass transition temperature and an effect of suppressing reduction in modulus of elasticity can be obtained.

On the other hand, a larger value taken by the parameter α indicates that the epoxy resin composition has extremely larger change in reactivity dependent on a temperature. When the parameter α is 1000 or less, reaction is not too fast in heating the epoxy resin composition. Thus, filling properties are secured, and a uniformly cured structure can be maintained. Curing reaction also progresses sufficiently without the need of an excessive quantity of heat for causing change in reactivity. Thus, a desired glass transition temperature and an effect of suppressing reduction in modulus of elasticity can be obtained.

Thus, the parameter α has the optimum range from the viewpoint of the filling properties of the epoxy resin composition and the physical properties of a cured product, and the range is presumably 690 ≤ α ≤ 1000.

The parameter α is controlled by the combination of the types or amounts of the epoxy resin and a curing agent or a curing accelerator and the like used in the epoxy resin composition.

For example, an epoxy resin having an aromatic ring as the epoxy resin tends to work to decrease α, and an aliphatic epoxy resin tends to work to increase α. A smaller epoxy equivalent tends to work to decrease α, and a larger epoxy equivalent tends to work to increase α.

As for the curing agent or the curing accelerator, the parameter α is appropriately adjusted by selecting a component (D) mentioned later and an additional curing agent. For example, a curing agent having higher reactivity tends to work to decrease α, and a curing agent having lower reactivity tends to work to increase α.

Thus, the parameter α of the epoxy resin composition is adjusted to the range of 690 ≤ α ≤ 1000 by appropriately selecting the materials used, whereby desired filling properties and the physical properties of a cured product can be achieved.

The parameter α is 690 or more, more preferably 695 or more, further preferably 700 or more, from the viewpoint of obtaining the effect. The parameter α is 1000 or less, more preferably 990 or less, further preferably 980 or less, even further preferably 970 or less, still further preferably 960 or less, particularly preferably 950 or less, from the same viewpoint as above.

### (Component (C): filler)

The epoxy resin composition of the present embodiment may further comprise a filler (hereinafter, also referred to as a filler (C) or a component (C)).

The filler (C) is not particularly limited and is one or two or more members selected from the group consisting of, for example, an inorganic filler and an inorganic filler treated in advance with a silane coupling agent (G) mentioned later, from the viewpoint of reducing warpage as well as, for example, an organic filler from the viewpoint of improving adhesion strength and improving crack resistance.

One of these fillers may be used singly, or two or more thereof may be used in combination.

The filler (C) is not particularly limited by its shape and may be in any form, for example, an amorphous, spherical, or scale-like form.

It is preferred to comprise an inorganic filler from the viewpoint of allowing the epoxy resin composition of the present embodiment and an adherend base material to have similar coefficients of linear expansion, and reducing warpage.

Examples of the inorganic filler include, but are not limited to, ceramics such as silica, alumina, glass, cordierite, silicone oxide, barium sulfate, barium carbonate, talc, clay, mica powders, zinc oxide, hydrotalcite, boehmite, aluminum hydroxide, magnesium hydroxide, calcium carbonate, magnesium carbonate, magnesium oxide, boron nitride, aluminum nitride, manganese nitride, aluminum borate, strontium carbonate, strontium titanate, calcium titanate, magnesium titanate, bismuth titanate, titanium oxide, zirconium oxide, barium titanate, barium zirconate titanate, barium zirconate, calcium zirconate, zirconium phosphate, and zirconium tungstate phosphate, carbons such as carbon nanotube and graphene, metals or alloys such as gold, silver, copper, nickel, aluminum, zinc, tin, lead, solder, indium, and palladium, and particles of polymer core materials coated with metal thin films.

Among them, it is preferred to comprise silica from the viewpoint of more reducing the warpage of a cured product. Examples of the silica include amorphous silica, fused silica, crystalline silica, synthetic silica, and hollow silica. Its shape is more preferably a spherical shape from the viewpoint of favorable filling properties or handleability of the epoxy resin composition.

Examples of the commercially available spherical fused silica include, but are not particularly limited to, trade names: SO-C2, SO-C1, SO-E2, and SO-E1 manufactured by Admatechs Co., Ltd.

The epoxy resin composition of the present embodiment preferably comprises, as the inorganic filler, for example, thermally conductive ceramic particles or metal particles, specifically, preferably comprises, for example, alumina particles, aluminum nitride particles, boron nitride particles, zinc oxide particles, silicon nitride particles, silicon carbide particles, magnesium oxide particles, gold particles, silver particles, nickel particles, or particles coated with a thin film of any of these metals, in the case of imparting thermal conductivity thereto, and, for example, alumina particles, aluminum nitride particles, boron nitride particles, gold particles, or silver particles are more preferred from the viewpoint of dispersibility, high thermal conductivity, and oxidative degradation resistance.

The average particle size of the filler (C) is not particularly limited and is preferably 20 µm or smaller, more preferably 10 µm or smaller, further preferably 5 µm or smaller, more preferably 3 µm or smaller, still further preferably 2 µm or smaller, even further preferably 1 µm or smaller, particularly preferably 0.5 µm or smaller, from the viewpoint of filling properties into fine space and close contact or adhesion using the epoxy resin composition containing the component (C).

On the other hand, the average particle size of the component (C), i.e., the filler, is preferably 0.01 µm or larger, more preferably 0.03 µm or larger, further preferably 0.05 µm or larger, even further preferably 0.07 µm or larger, particularly preferably 0.1 µm or larger, from the viewpoint of attaining a moderate viscosity and preparing a resin paste having favorable handleability in forming a resin paste using the epoxy resin composition.

In the present embodiment, the average particle size of the filler can be measured by a laser diffraction/scattering method based on the Mie scattering theory. Specifically, the particle size distribution of the filler is prepared on a volume basis with a laser diffraction particle size distribution analyzer, and a median size thereof can be measured as the average particle size. For example, trade name: HELOS manufactured by Sympatec GmbH can be used as the laser diffraction particle size distribution analyzer.

The content of the filler (C) can be appropriately set depending on the contents of the components (A) and (B).

In the case of using the inorganic filler as the filler (C), the content of the inorganic filler in the epoxy resin composition of the present embodiment can be appropriately set depending on desired performance and is not particularly limited. The content is preferably 5 to 98% by mass, more preferably 10 to 95% by mass, further preferably 15 to 90% by mass, still further preferably 20 to 88% by mass, even further preferably 25 to 85% by mass, particularly preferably 30 to 80% by mass, in all involatile components except for a solvent.

Within this range, the epoxy resin composition of the present embodiment can further exert effects (i) to (iii): (i) a proper viscosity can be kept, and handleability is excellent, (ii) the amounts of a resin component and the inorganic filler fall within right ranges so that adhesion, close contact, and dimensional stability are excellent, and (iii) warpage, the suppression of reduction in modulus of elasticity in a high-temperature region, and breaking strength are excellent when the resin composition is cured.

The organic filler has a function as an impact-resistant relaxing agent having stress relaxing properties. The epoxy resin composition of the present embodiment contains the organic filler, whereby adhesion to various connection members can be further improved, and the generation and progression of fillet cracks tend to be able to be suppressed.

Examples of the organic filler include, but are not limited to, acrylic resins, silicone resins, butadiene rubber, polyester, polyurethane, polyvinyl butyral, polyarylate, polymethyl methacrylate, acrylic rubber, polystyrene, acrylonitrile-butadiene rubber (NBR), styrene-butadiene rubber (SBR), silicone-modified resins, and organic fine particles of copolymers containing these components.

The organic fine particles are preferably, for example, an alkyl (meth)acrylate-butadiene-styrene copolymer, an alkyl (meth)acrylate-silicone copolymer, a silicone-(meth)acrylic copolymer, a composite of silicone and (meth)acrylic acid, a composite of alkyl (meth)acrylate-butadiene-styrene and silicone, or a composite of alkyl (meth)acrylate and silicone, from the viewpoint of improvement in adhesion.

Organic fine particles having a core-shell structure where a core layer and a shell layer differ in composition can also be used as the organic filler.

Examples of the core-shell organic fine particles include, but are not particularly limited to, particles of acrylic resins grafted to silicone-acrylic rubber as a core, and particles of acrylic resins grafted to acrylic copolymers.

The modulus of elasticity is reduced by the contained core-shell organic fine particles, whereby stress generated in a fillet moiety is reduced, and fillet cracks tend to be able to be prevented. If fillet cracks occur, the contained core-shell organic fine particles act as a stress relaxing agent and tend to suppress the progression of the fillet cracks.

A material excellent in softness is preferably used as a material constituting the core layer. Examples of the material constituting the core layer include, but are not limited to, silicone-based elastomers, butadiene-based elastomers, styrene-based elastomers, acrylic elastomers, polyolefin-based elastomers, and silicone/acrylic composite-based elastomers.

On the other hand, a material constituting the shell layer is preferably a material excellent in affinity for other components of a semiconductor resin sealing material, particularly, affinity for an epoxy resin. Examples of the material constituting the shell layer include, but are not particularly limited to, acrylic resins and epoxy resins. Among them, an acrylic resin is particularly preferred from the viewpoint of affinity for other components of a sealing material, particularly, affinity for an epoxy resin.

In the case of using the organic filler as the filler (C), the content of the organic filler in the epoxy resin composition of the present embodiment can be appropriately set depending on desired performance and is not particularly limited. The content is preferably 1 to 20% by mass, more preferably 2 to 18% by mass, further preferably 3 to 16% by mass, with respect to the total amount of the epoxy resin composition.

The content of the organic filler is 1% by mass or more, whereby stress relaxation works, and an effect of improving adhesive force tends to be obtained.

The content of the organic filler is 20% by mass or less, whereby an effect of thermal reflow resistance tends to be obtained.

### (Component (D): additional curing agent)

The epoxy resin composition of the present embodiment may further comprise a curing agent except for component (B): the compound of the general formula (1) and/or (2) mentioned above (hereinafter, also referred to as a curing agent (D) or a component (D)).

Conventionally known curing agents for use in epoxy resins can be widely used as the component (D). Examples thereof include, but are not particularly limited to, amine-based curing agents, amide-based curing agents, phenol-based curing agents, acid anhydride-based curing agents, imidazole-based curing agents (except for the component (B)), active ester-based curing agents, cyanate ester-based curing agents, carbodiimide-based curing agents, benzoxazine-based curing agents, phosphorus-based curing agents, thiol-based curing agents, catalyst-type curing agents, and their modified products.

One of these curing agents may be used singly, or two or more thereof may be used in combination.

Examples of the amine-based curing agent include, but are not limited to, aliphatic amine, aromatic amine, 4-dimethylaminopyridine, benzyldimethylamine, 2,4,6,-tris(dimethylaminomethyl)phenol, and 1,8-diazabicyclo(5.4.0)-undecene.

Examples of the aliphatic amine include, but are not limited to, triethylamine, tributylamine, diethylenetriamine, triethylenetetraamine, tetraethylenepentamine, m-xylenediamine, trimethylhexamethylenediamine, 2-methylpentamethylenediamine, isophoronediamine, 1,3-bisaminomethylcyclohexane, 1,4-bisaminomethylcyclohexane, bis(4-aminocyclohexyl)methane, norbornenediamine, and 1,2-diaminocyclohexane.

Examples of the aromatic amine include, but are not limited to, diaminodiphenylmethane, m-phenylenediamine, diaminodiphenylsulfone, diethyltoluenediamine, 1-methyl-3,5-diethyl-2,4-diaminobenzene, 1-methyl-3,5-diethyl-2,6-diaminobenzene, 1,3,5-triethyl-2,6-diaminobenzene, 3,3'-diethyl-4,4'-diaminodiphenylmethane, 3,5,3',5'-tetramethyl-4,4'-diaminodiphenylmethane, trimethylenebis(4-amino benzoate), polytetramethylene oxide-di-p-amino benzoate, aminobenzylamine, trade name: jERCURE WA manufactured by Mitsubishi Chemical Group Corp., trade name: KAYAHARD A-A manufactured by Nippon Kayaku Co., Ltd., and trade names: ETACURE 100, ETACURE 100 Plus, ETACURE 300, and ETACURE 420 manufactured by Mitsui Fine Chemicals, Inc.

Among those described above, it is preferred to comprise aromatic amine from the viewpoint of a favorable glass transition temperature, and it is more preferred to comprise diethyltoluenediamine, 1-methyl-3,5-diethyl-2,4-diaminobenzene, 1-methyl-3,5-diethyl-2,6-diaminobenzene, 1,3,5-triethyl-2,6-diaminobenzene, 3,3'-diethyl-4,4'-diaminodiphenylmethane, or 3,5,3',5'-tetramethyl-4,4'-diaminodiphenylmethane from the viewpoint of excellent handleability in a liquid state, filling properties, and close contact.

Examples of the amide-based curing agent include, but are not limited to, dicyandiamide and its derivative guanidine compounds, acid anhydride adducts of amine-based curing agents, and hydrazide compounds. It is preferred to comprise dicyandiamide or a hydrazide compound from the viewpoint of high adhesion and availability.

Examples of the hydrazide-based curing agent composed of the hydrazide compound include, but are not limited to, dihydrazide succinate, dihydrazide adipate, dihydrazide phthalate, dihydrazide isophthalate, dihydrazide terephthalate, hydrazide p-oxybenzoate, hydrazide salicylate, hydrazide phenylaminopropionate, and dihydrazide maleate.

Examples of the guanidine-based curing agent composed of the guanidine compound include, but are not limited to, dicyandiamide, dicyandiamide derivatives such as dicyandiamide-aniline adducts, dicyandiamide-methylaniline adducts, dicyandiamide-diaminodiphenylmethane adducts, and dicyandiamide-diamino diphenyl ether adducts, guanidine salts such as guanidine nitrate, guanidine carbonate, guanidine phosphate, guanidine sulfamate, and aminoguanidine bicarbonate, methylguanidine, ethylguanidine, propylguanidine, butylguanidine, dimethylguanidine, trimethylguanidine, tetramethylguanidine, pentamethylguanidine, cyclohexylguanidine, phenylguanidine, diphenylguanidine, toluylguanidine, acetylguanidine, diacetylguanidine, propionylguanidine, dipropionylguanidine, cyanoacetylguanidine, guanidine succinate, diethylcyanoacetylguanidine, dicyandiamidine, N-oxymethyl-N'-cyanoguanidine, N,N'-dicarboethoxyguanidine, 1,5,7-triazabicyclo[4.4.0]dec-5-ene, 7-methyl-1,5,7-triazabicyclo[4.4.0]dec-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide.

Examples of the phenol-based curing agent include, but are not limited to, phenol novolac resin, bisphenol A novolac resin, cresol novolac resin, phenol aralkyl resin, cresol aralkyl resin, naphthol-phenol co-condensed novolac resin, naphthol-cresol co-condensed novolac resin, allyl acryl phenol resin, dicyclopentadiene skeleton-containing phenol resin, biphenyl skeleton-containing phenol resin, naphthalene skeleton-containing phenol resin, and triazine skeleton-containing phenol resin. The triazine skeleton-containing phenol resin functions as a curing agent for epoxy resins and has both of a triazine skeleton and a structure derived from a phenol compound in one molecule. This curing agent is generally produced by the condensation of a phenol compound, a compound having a triazine ring, such as melamine or benzoguanamine, and formaldehyde.

Among them, it is preferred to comprise a phenol-based curing agent having a bisphenol A-type structure, a bisphenol F-type structure, a bisphenol AF-type structure, a naphthalene structure, a phenol novolac structure, a cyclohexane structure, a cyclohexanedimethanol structure, a butadiene structure, a biphenyl-type structure, a bixylenol structure, a cresol novolac structure, a dicyclopentadiene structure, a trisphenol structure, a naphthol structure, a naphthylene ether structure, an anthracene structure, a tetraphenylethane structure, a bisphenol acetophenone structure, a fluorene structure, or a triazine structure, from the viewpoint of a high glass transition temperature of a cured product, the suppression of reduction in modulus of elasticity, in a high-temperature region, and favorable strength.

Examples of the commercially available phenol-based curing agent include, but are not particularly limited to, trade names: TD2090 (phenol novolac resin), EXB-9500 (naphthalene skeleton-containing phenol resin), LA3018, LA3018-50P, LA7052, LA7054, and LA1356 (triazine skeleton-containing phenol resin) manufactured by DIC Corp., trade names: HF-1M (phenol novolac resin), MEH-7700, MEH-7810, and MEH-7851 (biphenyl skeleton-containing phenol resin) manufactured by UBE Corp., trade names: NHN, CBN, and GPH (naphthalene skeleton-containing phenol resin) manufactured by Nippon Kayaku Co., Ltd., and trade names: SN170, SN180, SN190, SN475, SN485, SN495, SN375, and SN395 (naphthalene skeleton-containing phenol resin) manufactured by NIPPON STEEL Chemical & Material Co., Ltd.

Examples of the acid anhydride-based curing agent include, but are not limited to, phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride, and methylhexahydrophthalic anhydride.

Examples of the imidazole-based curing agent except for the component (C) include, but are not limited to, 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine-isocyanuric acid adducts, 2-phenylimidazole-isocyanuric acid adducts, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, and 2-phenylimidazoline.

The active ester-based curing agent functions as a curing agent for epoxy resins and has active ester in a molecule.

When the epoxy resin composition of the present embodiment comprises the active ester-based curing agent as the component (D), a hydroxy group, which is responsible for increase in dielectric dissipation factor, derived from the reaction of active ester with an epoxy group does not appear in the epoxy resin composition; thus, the dielectric dissipation factor tends to be able to be decreased.

The active ester-based curing agent is not particularly limited and is preferably a compound having two or more active ester groups in one molecule from the viewpoint of securing a cross-link density. The active ester-based curing agent is more preferably an active ester compound obtained by reacting a carboxylic acid compound and/or a thiocarboxylic acid compound with a hydroxy compound and/or a thiol compound, further preferably an active ester compound obtained by reacting a carboxylic acid compound with one or two or more members selected from a phenol compound, a naphthol compound, and a thiol compound, from the viewpoint of a high glass transition temperature of the epoxy resin composition of the present embodiment and the suppression of reduction in modulus of elasticity in a high-temperature region, for example. The active ester-based curing agent is still further preferably an aromatic compound having two or more active ester groups in one molecule, the aromatic compound being obtained by reacting a carboxylic acid compound with an aromatic compound having a phenolic hydroxy group. The active ester-based curing agent is even further preferably an aromatic compound obtained by reacting a compound having at least two or more carboxylic acids in one molecule with an aromatic compound having a phenolic hydroxy group, or an aromatic compound having two or more active ester groups in one molecule of the aromatic compound described above.

The active ester-based curing agent may be linear or branched. The compound having at least two or more carboxylic acids in one molecule tends to be able to enhance compatibility with the epoxy resin when being a compound containing an aliphatic chain, and tends to further exert an effect of attaining a high glass transition temperature and suppressing reduction in modulus of elasticity in a high-temperature region when being a compound having an aromatic ring.

In this context, examples of the carboxylic acid compound include benzoic acid, acetic acid, succinic acid, maleic acid, itaconic acid, phthalic acid, isophthalic acid, terephthalic acid, and pyromellitic acid. The carboxylic acid compound is preferably succinic acid, maleic acid, itaconic acid, phthalic acid, isophthalic acid, or terephthalic acid, more preferably isophthalic acid or terephthalic acid, particularly, from the viewpoint of attaining a high glass transition temperature of the epoxy resin composition of the present embodiment and suppressing reduction in modulus of elasticity in a high-temperature region.

Examples of the thiocarboxylic acid compound include, but are not particularly limited to, thioacetic acid and thiobenzoic acid.

Examples of the phenol compound or the naphthol compound include, but are not particularly limited to, hydroquinone, resorcinol, bisphenol A, bisphenol F, bisphenol S, phenolphthalein, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucinol, benzenetriol, dicyclopentadienyl diphenol, and phenol novolac. Among them, the phenol or naphthol compound is preferably bisphenol A, bisphenol F, bisphenol S, methylated bisphenol A, methylated bisphenol F, methylated bisphenol S, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucinol, benzenetriol, dicyclopentadienyl diphenol, or phenol novolac, more preferably catechol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucinol, benzenetriol, dicyclopentadienyl diphenol, or phenol novolac, further preferably 1,5-dihydroxynaphthalene, 1,6-dihydroxynaphthalene, 2,6-dihydroxynaphthalene, dihydroxybenzophenone, trihydroxybenzophenone, tetrahydroxybenzophenone, dicyclopentadienyl diphenol, or phenol novolac, still further preferably dihydroxybenzophenone, trihydroxybenzophenone, tetrahydroxybenzophenone, dicyclopentadienyl diphenol, or phenol novolac, even further preferably dicyclopentadienyl diphenol or phenol novolac, particularly preferably dicyclopentadienyl diphenol, from the viewpoint of a high glass transition temperature, the suppression of reduction in modulus of elasticity in a high-temperature region, and solubility in the epoxy resin or a solvent.

Examples of the thiol compound include, but are not particularly limited to, benzenedithiol and triazinedithiol.

The active ester compound serving as the active ester-based curing agent is not particularly limited. For example, an active ester compound disclosed in Japanese Patent Laid-Open No. 2004-277460 or 2013-40270 may be used, and a commercially available active ester compound can also be used. Examples of the commercially available active ester compound include, but are not particularly limited to, trade names: EXB9451, EXB9460, EXB9460S, HPC-8000-65T (active ester compound having a dicyclopentadiene-type diphenol structure), EXB9416-70BK (active ester compound having a naphthalene structure), and EXB9050L-62M (phosphorus atom-containing active ester compound) manufactured by DIC Corp., and trade names: DC808 (active ester compound containing an acetylated product of phenol novolac) and YLH1026 (active ester compound containing a benzoylated product of phenol novolac) manufactured by Mitsubishi Chemical Group Corp.

The cyanate ester-based curing agent functions as a curing agent for epoxy resins and has a cyanate group in a molecule. The epoxy resin composition of the present embodiment comprises the cyanate ester-based curing agent as the component (D), whereby flexibility is imparted to the epoxy resin composition by forming an oxazoline ring or an oxazolidinone ring through reaction with an epoxy group, while triazine skeleton formation occurs by the trimerization of a cyanate group; thus, a particularly high glass transition temperature tends to be obtained with warpage reduced. Furthermore, a hydroxy group is unlikely to appear during reaction; thus, a dielectric dissipation factor tends to be able to be kept low.

Examples of the cyanate ester-based curing agent include, but are not limited to, novolac-type (phenol novolac-type, alkylphenol novolac-type, etc.) cyanate ester resin, dicyclopentadiene-type cyanate ester resin, bisphenol-type (bisphenol A-type, bisphenol F-type, bisphenol S-type, etc.) cyanate ester resin, and prepolymers obtained by partially converting these resins to triazine. Specific examples of the cyanate ester resin include bifunctional cyanate resins such as bisphenol A dicyanate, polyphenol cyanate (oligo(3-methylene-1,5-phenylene cyanate), 4,4'-methylenebis(2,6-dimethylphenyl cyanate), 4,4'-ethylidene diphenyl dicyanate, hexafluorobisphenol A dicyanate, 2,2-bis(4-cyanato)phenylpropane, 1,1-bis(4-cyanatophenylmethane), bis(4-cyanato-3,5-dimethylphenyl)methane, 1,3-bis(4-cyanatophenyl-1-(methylethylidene))benzene, and bis(4-cyanatophenyl)thio ether, bis(4-cyanatophenyl) ether, polyfunctional cyanate resins such as phenol novolac, cresol novolac, and dicyclopentadiene structure-containing phenol resin, and prepolymers obtained by partially converting these cyanate resins to triazine.

One of these resins may be used, or two or more thereof may be used in combination.

Examples of the commercially available cyanate ester resin include, but are not particularly limited to, trade name: CYTESTER(R) TA (bisphenol A-type cyanate ester resin) manufactured by Mitsubishi Gas Chemical Co., Inc.

Examples of the carbodiimide-based curing agent include, but are not limited to, trade names: CARBODILITE V-02B, V-03, V-04K, V-07, and V-09 manufactured by Nisshinbo Chemical Inc., and trade name: STABAXOL P, P400, and HAICADIL 510 manufactured by Rhein Chemie Corp. A modified product of a carbodiimide compound as disclosed in Japanese Patent No. 7226954 may be used.

Examples of the benzoxazine-based curing agent include, but are not limited to, trade name: HFB2006M manufactured by Showa HighPolymer Co., Ltd., and trade names: P-d, F-a, and ALP-d manufactured by Shikoku Kasei Holdings Corp.

Examples of the phosphorus-based curing agent include, but are not limited to, triphenylphosphine, phosphonium borate compounds, tetraphenylphosphonium tetraphenyl borate, n-butylphosphonium tetraphenyl borate, tetrabutylphosphonium decanoate, (4-methylphenyl)triphenylphosphonium thiocyanate, tetraphenylphosphonium thiocyanate, and butyltriphenylphosphonium thiocyanate.

The thiol-based curing agent can contain two or more thiol groups in one molecule. Examples thereof include, but are not limited to, 3,3'-dithiodipropionic acid, trimethylolpropane tris(thioglycolate), pentaerythritol tetrakis(thioglycolate), ethylene glycol dithioglycolate, 1,4-bis(3-mercaptobutyryloxy)butane, tris[(3-mercaptopropionyloxy)-ethyl]-isocyanurate, 1,3,5-tris(3-mercaptobutyloxyethyl)-1,3,5-triazine-2,4,6(1H,3H,5H)-trione, trimethylolpropane tris(3-mercaptopropionate), pentaerythritol tetrakis(3-mercaptopropionate), pentaerythritol tetrakis(3-mercaptobutyrate), dipentaerythritol hexakis(3-mercaptopropionate), 1,3,4,6-tetrakis(2-mercaptoethyl) glycoluril, 4-butanedithiol, 1,6-hexanedithiol, and 1,10-decanedithiol. The thiol-based curing agent is preferably 1,4-bis(3-mercaptobutyryloxy)butane, 1,3,5-tris(3-mercaptobutyloxyethyl)-1,3,5-triazine-2,4,6(1H,3H,5H)-trione, pentaerythritol tetrakis(3-mercaptopropionate), or pentaerythritol tetrakis(3-mercaptobutyrate) from the viewpoint of the impact resistance of a cured product of the epoxy resin composition of the present embodiment, more preferably pentaerythritol tetrakis(3-mercaptopropionate), pentaerythritol tetrakis(3-mercaptobutyrate) from the viewpoint of the low-temperature curability of the epoxy resin composition of the present embodiment.

Examples of the catalyst-type curing agent include, but are not limited to, cationic thermosetting catalysts and BF₃-amine complexes.

Examples of the modified product serving as the curing agent include, but are not limited to, polyamine compounds, amine-epoxy adducts, amine-urea adducts, imidazole-epoxy adducts, aminimide compounds, and microcapsule-type curing agents prepared by coating these compounds and curing agents prepared by adsorbing these compounds onto porous materials. Specific examples thereof include, but are not limited to, trade names: NOVACURE HX-3722, HX-3742, HX-3088, HX-3613, HXA3932HP, HXA9322HP, HXA9382HP, and HXA9192HP manufactured by Asahi Kasei Corp., trade names: AMICURE PN-23J, PN-40J, and MY-24 manufactured by Ajinomoto Fine-Techno Co., Inc., and trade names: FUJICURE FXR-1020 and FXR-1030 manufactured by Fuji Kasei Kogyo Co., Ltd.

The content of the component (D) in the epoxy resin composition of the present embodiment can be appropriately set depending on the reactivity of the component (A) or the component (B) mentioned above and desired performance and is not particularly limited. The content is preferably 0.01% by mass or more, more preferably 0.1% by mass or more, further preferably 1.0% by mass or more, in all involatile components except for a solvent from the viewpoint of obtaining favorable reactivity. The content is preferably 50% by mass or less, more preferably 40% by mass or less, further preferably 30% by mass or less, from the viewpoint of obtaining favorable storage stability.

### (Component (E): thermoplastic resin)

The epoxy resin composition of the present embodiment may further comprise a thermoplastic resin (hereinafter, also referred to as a thermoplastic resin (E) or a component (E)).

The epoxy resin composition of the present embodiment comprises the thermoplastic resin (E), whereby in the case of molding the epoxy resin composition of the present embodiment into a film by casting or by coating and drying at a given thickness, cracks or breakage is prevented, and the film shape can be maintained.

Examples of the thermoplastic resin (E) include, but are not limited to, phenoxy resins, polyvinylacetal resins, acid anhydride group-containing vinyl resins, polyolefin resins, polybutadiene resins, polyimide resins, polyamideimide resins, styrene-based elastomer resins, polyethersulfone resins, polyphenylene ether resins, polysulfone resins, and acrylic resins.

One of these thermoplastic resins (E) may be used singly, or two or more thereof may be used in combination.

The weight-average molecular weight of the thermoplastic resin (E) is preferably 10000 or higher, more preferably 15000 or higher, further preferably 20000 or higher, still further preferably 25000 or higher or 30000 or higher, from the viewpoint of obtaining a cured product layer having sufficient strength. The upper limit of the weight-average molecular weight of the thermoplastic resin (E) is preferably 200000 or lower, more preferably 180000 or lower, further preferably 160000 or lower, still further preferably 150000 or lower, from the viewpoint of obtaining favorable compatibility. In the present embodiment, the weight-average molecular weight of the thermoplastic resin (E) can be measured by, for example, gel permeation chromatography (GPC). Specifically, the weight-average molecular weight (polystyrene-based) of the thermoplastic resin can be calculated by using HLC-8320GPC manufactured by Tosoh Corp. as a measurement apparatus, ShodeX KF-804/KF-803/KF-802/KF-802 manufactured by Resonac Corp. as a column, and tetrahydrofuran or the like as a mobile phase, performing measurement at a column temperature of 40°C, and using a calibration curve of standard polystyrene.

The thermoplastic resin (E) preferably has a functional group containing one or more atoms selected from the group consisting of an oxygen atom, a nitrogen atom, and a sulfur atom, or a carbon-carbon double bond, from the viewpoint of attaining sufficient the glass transition temperature and strength of a cured product. The functional group is one or more members selected from the group consisting of a hydroxy group, a carboxy group, an acid anhydride group, an epoxy group, an amino group, a thiol group, an enol group, an enamine group, a urea group, a cyanate group, an isocyanate group, a thioisocyanate group, a diimide group, an alkenyl group, an arene group, and a ketene group. The acid anhydride group is preferably a carboxylic anhydride group. Preferred examples of the alkenyl group include a vinyl group, an allyl group, and a styryl group. When the thermoplastic resin contains such a functional group, the functional group equivalent of the thermoplastic resin (G) is preferably 100000 or less, more preferably 90000 or less, 80000 or less, 70000 or less, 60000 or less, 50000 or less, 40000 or less, 30000 or less, 20000 or less, 10000 or less, 8000 or less, 6000 or less, or 5000 or less. The lower limit of the functional group equivalent is not particularly limited and can be usually 50 or more or 100 or more, for example.

Hereinafter, suitable thermoplastic resins (E) will be described in more detail. Thermoplastic resin prepared by further adding the functional groups described above to the following thermoplastic resins can also be suitably used as the component (E) according to known procedures.

For example, a phenoxy resin having one or more skeletons selected from the group consisting of a bisphenol A skeleton, a bisphenol F skeleton, a bisphenol S skeleton, a bisphenol acetophenone skeleton, a phenol novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton can be suitably used. The phenoxy resin may have any terminal functional group such as a phenolic hydroxy group or an epoxy group.

Specific examples of the phenoxy resin include, but are not particularly limited to, trade names: 1256, 4250 (bisphenol A skeleton-containing phenoxy resin), YX8100 (bisphenol S skeleton-containing phenoxy resin), YX6954, YX6954BH30 (bisphenol acetophenone skeleton-containing phenoxy resin), YX7553, YX7553BH30 (biscresol fluorenone skeleton-containing phenoxy resin), YL6794 (terpene skeleton-containing phenoxy resin), YL7213, YL7290 (trimethylcyclohexane skeleton-containing phenoxy resin), YL7500BH30, YL7769BH30, and YL7482 manufactured by Mitsubishi Chemical Group Corp., and trade names: FX280 and FX293 (bisphenol fluorenone skeleton-containing phenoxy resin) manufactured by NIPPON STEEL Chemical & Material Co., Ltd.

Specific examples of the polyvinylacetal resin include, but are not particularly limited to, trade names: Denka Butyral 4000-2, 5000-A, 6000-C, and 6000-EP from Denka Co., Ltd., and trade names: SLEC BH series, BX series, KS series (e.g., KS-1), BL series, and BM series manufactured by Sekisui Chemical Co., Ltd.

The acid anhydride group-containing vinyl resin can be obtained by, for example, but not particularly limited to, the copolymerization of an acid anhydride group-containing monomer (d1) and an additional monomer (d2). Examples of the acid anhydride group-containing monomer (d1) include, but are not particularly limited to, maleic anhydride, itaconic anhydride, citraconic anhydride, and aconitic anhydride. The additional monomer (d2) is not particularly limited as long as the monomer is copolymerizable with the acid anhydride group-containing monomer (d1). For example, an ethylenic unsaturated monomer such as (meth)acrylic acid, (meth)acrylic acid ester, or styrene can be used. Specific examples of the acid anhydride group-containing vinyl resin include, but are not limited to, trade names: EF-30, EF-40, EF-60, and EF-80 manufactured by Cray Valley SA.

Specific examples of the polyimide resin include, but are not particularly limited to, trade names: RICACOAT SN-20 and PN-20 manufactured by New Japan Chemical Co., Ltd., and trade name: UNIDIC V-8000 manufactured by DIC Corp.

Specific examples of the polyimide resin also include modified polyimide such as linear polyimide obtained by reacting bifunctional hydroxyl group-terminated polybutadiene, a diisocyanate compound, and tetrabasic anhydride (Japanese Patent Laid-Open No. 2006-37083) and polysiloxane skeleton-containing polyimide (Japanese Patent Laid-Open No. 2002-12667, Japanese Patent Laid-Open No. 2000-319386, WO 2010/53186, etc.).

Specific examples of the polyamideimide resin include, but are not particularly limited to, trade names: VYLOMAX HR11NN and HR16NN manufactured by Toyobo Co., Ltd., and trade names: HPC-5020, HPC-6000, HPC-7200, and HPC-9000 manufactured by Resonac Corp.

Examples of the styrene-based elastomer resin include, but are not particularly limited to, block copolymers comprising a block of styrene or its analog as at least one terminal block and comprising an elastomer block of conjugated diene or its hydrogenated product as at least one intermediate block. Specific examples thereof include styrene-butadiene diblock copolymers, styrene-butadiene triblock copolymers, styrene-isoprene diblock copolymers, styrene-isoprene triblock copolymers, hydrogenated styrene-butadiene diblock copolymers, hydrogenated styrene-butadiene triblock copolymers, hydrogenated styrene-isoprene diblock copolymers, hydrogenated styrene-isoprene triblock copolymers, and hydrogenated styrene-butadiene random copolymers. Specific examples of the styrene-based elastomer resin include, but are not particularly limited to, trade names: ASAPRENE, TUFPRENE, and ASAPLEX manufactured by Asahi Kasei Corp., and trade names: HYBRAR and SEPTON manufactured by Kuraray Co., Ltd.

Specific examples of the polyethersulfone resin include, but are particularly limited to, trade name: PES5003P manufactured by Sumitomo Chemical Co., Ltd.

Specific examples of the polysulfone resin include, but are not limited to, trade names: Polysulfone P1700 and P3500 manufactured by Solvay Advanced Polymers, LLC.

Specific examples of the polybutadiene resin include, but are not limited to, trade names: G-1000, G-3000, GI-1000, and GI-3000 manufactured by Nippon Soda Co., Ltd., trade name: R-45EPI manufactured by Idemitsu Petrochemical Co., Ltd., trade name: EPOFRIEND AT501 manufactured by Daicel Corp., and trade names: Ricon 130, Ricon 142, Ricon 150, Ricon 657, and Ricon 130MA manufactured by Cray Valley SA.

Specific examples of the acrylic resin include, but are not limited to, trade names: SG-P3, SG-600LB, SG-280, SG-790, and SG-K2 manufactured by Nagase ChemteX Corp., and trade names: SN-50, AS-3000E, and ME-2000 manufactured by Negami Chemical Industrial Co., Ltd.

Among them, it is preferred to comprise, as the thermoplastic resin (E), one or more members selected from the group consisting of a phenoxy resin, a polyvinylacetal resin, an acid anhydride group-containing vinyl resin, a polyimide resin, a polyamideimide resin, a styrene-based elastomer resin, and an acrylic resin from the viewpoint of securing long-term connection reliability through a sufficient glass transition temperature and strength of a cured layer obtained using the epoxy resin composition of the present embodiment, and securing uniform curability by keeping compatibility proper with the epoxy resin (A).

In the case of applying the epoxy resin composition of the present embodiment to, for example, a material to be integrated in a bent form into an electronic device, such as a flexible wiring board, the contained thermoplastic resin (E) can attain reduction in elasticity of a cured product layer of the epoxy resin composition and can suppress fracturing or peeling. For purposes requiring such reduction in elasticity, it is preferred to comprise, as the thermoplastic resin (E), but not limited to, a resin having one or more structures selected from a polybutadiene structure, a polysiloxane structure, a poly(meth)acrylate structure, a polyalkylene structure, a polyalkyleneoxy structure, a polyisoprene structure, a polyisobutylene structure, and a polycarbonate structure in a molecule because an effect of reducing elasticity is easily obtained. A thermoplastic resin that has a glass transition temperature of 25°C or lower or is in a liquid state at 25°C can also be suitably used from the viewpoint of obtaining the effect of reducing elasticity.

The content of the thermoplastic resin (E) in the epoxy resin composition of the present embodiment can be appropriately set depending on the types and contents of the components (A) to (D) used, and desired performance and is not particularly limited. The content is preferably 0.5% by mass or more, more preferably 1% by mass or more, further preferably 1.2% by mass or more, still further preferably 1.5% by mass or more, in all involatile components except for a solvent from the viewpoint of securing the close contact and flexibility of the epoxy resin composition of the present embodiment. The content is preferably 50% by mass or less, more preferably 40% by mass or less, further preferably 30% by mass or less, still further preferably 20% by mass or less, from the viewpoint of attaining a high glass transition temperature of the epoxy resin composition of the present embodiment, suppressing reduction in modulus of elasticity in a high-temperature region, and keeping strength favorable.

### (Component (F): solvent)

The epoxy resin composition of the present embodiment may further comprise a solvent (hereinafter, also referred to as a solvent (F) or a component (F)).

The epoxy resin composition of the present embodiment comprises the solvent (F), whereby the compound as the component (B) mentioned above tends to be homogeneously dissolved in the epoxy resin composition. This improves uniform curability of a cured product layer made of the epoxy resin composition of the present embodiment. Furthermore, composition that can further exert the advantageous effects of the present invention is easily designed by selecting components (B) having various structures depending on a desired reaction temperature zone or reaction rate.

The solvent (F) is not particularly limited, and a known solvent can be used.

Examples of the solvent (F) include, but are not limited to: hydrocarbons such as benzene, toluene, xylene, cyclohexane, mineral spirits, and solvent naphtha, ketones such as acetone, methyl ethyl ketone (MEK), methyl isopropyl ketone, methyl isobutyl ketone, cyclohexanone, and acetophenone; esters such as ethyl acetate, n-butyl acetate, propylene glycol monomethyl ethyl ether acetate, and γ-butyrolactone; alcohols such as methanol, ethanol, isopropanol, n-butanol, butyl cellosolve, butyl carbitol, 2-phenoxyethanol, and 1-methoxy-2-propanol; and amide-based solvents such as dimethylformamide, dimethylacetamide, and N-methylpyrrolidone.

One of these solvents may be used singly, or two or more thereof may be used in combination.

The content of the solvent (F) in the epoxy resin composition of the present embodiment is not particularly limited. In the case of blending the solvent therewith for use as a varnish or a paste, the content is preferably 5 to 80% by mass, more preferably 10 to 75% by mass, further preferably 15 to 70% by mass, still further preferably 20 to 65% by mass, even further preferably 25 to 60% by mass, with respect to the whole epoxy resin composition from the viewpoint of attaining favorable handleability by uniformly dissolving various components and controlling a viscosity to a proper range.

When other components contain a solvent, for example, when the component (D) contains a solvent, the content also includes such a solvent and is in a preferred range of the proportion of the solvent in the whole epoxy resin composition.

In the case of preparing the epoxy resin composition of the present embodiment into a resin film, the content of the solvent (F) is not particularly limited and is preferably 10% by mass or less, more preferably 8% by mass or less, further preferably 6% by mass or less, with respect to the whole epoxy resin composition from the viewpoint of suppressing air bubble formation. On the other hand, the content is preferably 0.001% by mass or more, more preferably 0.01% by mass or more, further preferably 0.1% by mass or more, with respect to the whole epoxy resin composition from the viewpoint of preventing the close contact or flexibility of the resin film from being reduced due to excessive reduction in amount of the solvent.

### (Component (G): silane coupling agent)

The epoxy resin composition of the present embodiment may further comprise a silane coupling agent (hereinafter, also referred to as a silane coupling agent (G) or a component (G)).

It is preferred to comprise the silane coupling agent (G) because favorable affinity can be attained between a resin component and the filler or between a resin component and an adherend substrate, uniform dispersibility of the filler component is improved, and the adhesion of the epoxy resin composition tends to be improved.

In the present embodiment, the phrase "comprise a silane coupling agent (G)" means that in a process of obtaining the epoxy resin composition of the present embodiment, the silane coupling agent is integrated into the composition of the epoxy resin composition by any of the following methods (i) to (iii).

### Method (i):

A method of treating the filler (C) with the silane coupling agent and blending the filler thus treated into the epoxy resin composition.

### Method (ii):

A method of directly adding the silane coupling agent to the resin composition (integral blend method).

### Method (iii):

A method of reacting the silane coupling agent with an end or a side chain of the epoxy resin (A) or the thermoplastic resin (E) used, or blending a silylated resin using a resin of a monomer copolymerized with the silane coupling agent, for example.

Any of the methods (i) to (iii) mentioned above may be used. The method (i) is preferred from the viewpoint that an alcohol serving as a by-product of silane coupling reaction is unlikely to remain in the system and that the filler has much better dispersibility. The method (ii) or (iii) is preferred from the viewpoint that action can be made between the resin and the filler as well as between the resin and an adherend substrate, and adhesion and close contact can be more favorable.

The silane coupling agent (G) contains at least one hydrolyzable group such as an alkoxy group or an aryloxy group bonded to a silicon atom, and in addition to this, an alkyl group, an alkenyl group, or an aryl group may be bonded thereto. The alkyl group may be substituted by an amino group, an alkoxy group, an epoxy group, or a (meth)acryloyloxy group.

It is preferred to comprise, as the silane coupling agent (G), one or more silane coupling agents selected from, for example, but not limited to, an aminosilane-based coupling agent, an epoxysilane-based coupling agent, a mercaptosilane-based coupling agent, a styrylsilane-based coupling agent, an acrylate silane-based coupling agent, an isocyanate silane-based coupling agent, a sulfide silane-based coupling agent, a vinylsilane-based coupling agent, a silane-based coupling agent, an organosilazane compound, and a titanate-based coupling agent, from the viewpoint of improvement in uniform dispersibility of the filler component and improvement in adhesion and close contact of the resin composition.

Specific examples of the silane coupling agent (G) include, but are not limited to, aminosilane-based coupling agents such as 3-aminopropyltrimethoxysilane, 3-aminopropyltriethoxysilane, 3-aminopropyldiethoxymethylsilane, N-phenyl-3-aminopropyltrimethoxysilane, N-methylaminopropyltrimethoxysilane, N-2(-aminoethyl)-3-aminopropyltrimethoxysilane, and N-(2-aminoethyl)-3-aminopropyldimethoxymethylsilane, epoxysilane-based coupling agents such as 3-glycidyloxypropyltrimethoxysilane, 3-glycidyloxypropyltriethoxysilane, 3-glycidyloxypropylmethyldiethoxysilane, 3-glycidyloxypropyl(dimethoxy)methylsilane, glycidyl butyltrimethoxysilane, and 2-(3,4-epoxycyclohexyl)ethyltrimethoxysilane, mercaptosilane-based coupling agents such as 3-mercaptopropyltrimethoxysilane, 3-mercaptopropyltriethoxysilane, 3-mercaptopropylmethyldimethoxysilane, and **11-**mercaptoundecyltrimethoxysilane, styrylsilane-based coupling agents such as p-styryltrimethoxysilane, acrylate silane-based coupling agents such as 3-acryloxypropyltrimethoxysilane, 3-methacryloxypropyltrimethoxysilane, 3-methacryloxypropyldimethoxysilane, 3-methacryloxypropyltriethoxysilane, and 3-methacryloxypropyldiethoxysilane, isocyanate silane-based coupling agents such as 3-isocyanatopropyltrimethoxysilane, sulfide silane-based coupling agents such as bis(triethoxysilylpropyl) disulfide and bis(triethoxysilylpropyl) tetra sulfide, silane-based coupling agents such as methyltrimethoxysilane, octadecyltrimethoxysilane, phenyltrimethoxysilane, methacryloxypropyltrimethoxysilane, imidazole silane, triazine silane, and t-butyltrimethoxysilane, organosilazane compounds such as hexamethyldisilazane, 1,3-divinyl-1,1,3,3-tetramethyldisilazane, hexaphenyldisilazane, trisilazane, cyclotrisilazane, octamethylcyclotetrasilazane, hexabutyldisilazane, hexaoctyldisilazane, 1,3-diethyltetramethyldisilazane, 1,3-di-n-octyltetramethyldisilazane, 1,3-diphenyltetramethyldisilazane, 1,3-dimethyltetraphenyldisilazane, 1,3-diethyltetramethyldisilazane, 1,1,3,3-tetraphenyl-1,3-dimethyldisilazane, 1,3-dipropyltetramethyldisilazane, hexamethylcyclotrisilazane, dimethylaminotrimethylsilazane, and tetramethyldisilazane, and titanate-based coupling agents such as tetra-n-butyl titanate dimers, titanium-i-propoxyoctylene glycolate, tetra-n-butyl titanate, titanium octylene glycolate, diisopropoxy titanium bis(triethanol aminate), dihydroxy titanium bislactate, dihydroxy bis(ammonium lactate) titanium, bis(dioctyl pyrophosphate) ethylene titanate, bis(dioctyl pyrophosphate) oxyacetate titanate, tri-n-butoxy titanium monostearate, tetra-n-butyl titanate, tetra(2-ethylhexyl) titanate, tetraisopropylbis(dioctyl phosphite) titanate, tetraoctylbis(ditridecyl phosphite) titanate, tetra(2,2-diallyloxymethyl-1-butyl)bis(ditridecyl)phosphite titanate, isopropyltrioctanoyl titanate, isopropyltricumylphenyl titanate, isopropyltriisostearoyl titanate, isopropylisostearoyl diacryltitanate, isopropyldimethacrylisostearoyl titanate, isopropyltri(dioctyl phosphate) titanate, isopropyltridodecylbenzenesulfonyl titanate, isopropyl tris(dioctyl pyrophosphate) titanate, and isopropyltri(N-amidoethyl/aminoethyl) titanate.

Among them, the silane coupling agent is preferably an aminosilane-based coupling agent, an epoxysilane-based coupling agent, a mercaptosilane-based coupling agent, or an organosilazane compound, more preferably an aminosilane-based coupling agent from the viewpoint of filler fluidity upon combined use with the component (B).

Examples of the commercially available product include, but are not limited to, trade names: KBM403 (3-glycidoxypropyltrimethoxysilane), KBM803 (3-mercaptopropyltrimethoxysilane), KBE903 (3-aminopropyltriethoxysilane), KBM573 (N-phenyl-3-aminopropyltrimethoxysilane), and SZ-31 (hexamethyldisilazane) manufactured by Shin-Etsu Chemical Co., Ltd.

The content of the silane coupling agent (G) in the epoxy resin composition of the present embodiment is not particularly limited and is preferably 0.1 to 2.0 parts by mass with respect to 100 parts by mass of the filler (C) from the viewpoint of suppressing excessive side reaction while attaining favorable dispersibility of the filler (C) and adhesion and close contact of the epoxy resin composition of the present embodiment.

### (Component (H): non-epoxy group-terminated compound having polyalkylene oxide structure)

The epoxy resin composition of the present embodiment may further comprise a compound that has a polyalkylene oxide structure and is non-epoxy group-terminated (non-epoxy group-terminated compound having a polyalkylene oxide structure; hereinafter, also referred to as a component (H)) except for the components (A) to (G) mentioned above.

The component (H) is contained therein, whereby an effect of relaxing the internal stress of a cured product layer and suppressing warpage tends to be able to be obtained. The component (H) is more preferably a compound having a terminal hydroxy group from the viewpoint of the homogeneity of a cured product.

Examples of the component (H) include, but are not limited to: linear polyalkylene oxide glycol (linear polyalkylene glycol) such as polyethylene glycol, polypropylene glycol, and polyoxyethylene polyoxypropylene glycol; multi-chain polyalkylene oxide glycol (multi-chain polyalkylene glycol) such as polyoxyethylene glyceryl ether, polyoxypropylene glyceryl ether, polyoxyethylene polyoxypropylene glyceryl ether, polyoxyethylene trimethylolpropane ether, polyoxypropylene trimethylolpropane ether, polyoxyethylene polyoxypropylene trimethylolpropane ether, polyoxyethylene diglyceryl ether, polyoxypropylene diglyceryl ether, polyoxyethylene polyoxypropylene diglyceryl ether, polyoxyethylene pentaerythritol ether, polyoxypropylene pentaerythritol ether, polyoxyethylene polyoxypropylene pentaerythritol ether, polyoxyethylene sorbitol, polyoxypropylene sorbitol, and polyoxyethylene polyoxypropylene sorbitol; other polyalkylene oxide glycols (polyalkylene glycols); polyalkylene oxide alkyl ether such as polyoxyethylene monoalkyl ether, polyoxyethylene dialkyl ether, polyoxypropylene monoalkyl ether, polyoxypropylene dialkyl ether, polyoxyethylene polyoxypropylene monoalkyl ether, and polyoxyethylene polyoxypropylene dialkyl ether; polyalkylene oxide ester (including acetic acid ester, propionic acid ester, butyric acid ester, (meth)acrylic acid ester, and the like) such as polyoxyethylene monoester, polyoxyethylene diester, polypropylene glycol monoester, polypropylene glycol diester, polyoxyethylene polyoxypropylene monoester, and polyoxyethylene polyoxypropylene diester; polyalkylene oxide alkyl ether ester (including acetic acid ester, propionic acid ester, butyric acid ester, (meth)acrylic acid ester, and the like) such as polyoxyethylene monoester, polyoxyethylene diester, polyoxypropylene monoester, polyoxypropylene diester, polyoxyethylene polyoxypropylene monoester, polyoxyethylene polyoxypropylene diester, polyoxyethylene alkyl ether ester, polyoxypropylene alkyl ether ester, and polyoxyethylene polyoxypropylene alkyl ether ester; polyalkylene oxide alkylamine such as polyoxyethylene alkylamine, polyoxypropylene alkylamine, and polyoxyethylene polyoxypropylene alkylamine; polyalkylene oxide alkylamide such as polyoxyethylene alkylamide, polyoxypropylene alkylamide, and polyoxyethylene polyoxypropylene alkylamide; polyalkylene oxide-modified silicone such as polyoxyethylene dimethicone, polyoxypropylene dimethicone, polyoxyethylene polyoxypropylene dimethicone, polyoxyethylene polydimethylsiloxy alkyl dimethicone, polyoxypropylene polydimethylsiloxy alkyl dimethicone, and polyoxyethylene polyoxypropylene polydimethylsiloxy alkyl dimethicone; and alkyl etherified polyalkylene oxide-modified silicone (polyalkylene oxide-modified silicone having an alkoxy group at at least some ends of a polyether skeleton) such as polyoxyethylene alkyl ether dimethicone, polyoxypropylene alkyl ether dimethicone, polyoxyethylene polyoxypropylene alkyl ether dimethicone, polyoxyethylene alkyl ether polydimethylsiloxy alkyl dimethicone, polyoxypropylene alkyl ether polydimethylsiloxy alkyl dimethicone, and polyoxyethylene polyoxypropylene alkyl ether polydimethylsiloxy alkyl dimethicone.

Specific examples of the component (H) include, but are not particularly limited to, "PRONONE #102", "PRONONE #104", "PRONONE #201", "PRONONE #202B", "PRONONE #204", "PRONONE #208", "UNILUBE 70DP-600B", and "UNILUBE 70DP-950B" (polyoxyethylene polyoxypropylene glycol) manufactured by NOF Corp.; "PLURONIC L-23", "PLURONIC L-31", "PLURONIC L-44", "PLURONIC L-61", "ADEKA PLURONIC L-62", "PLURONIC L-64", "PLURONIC L-71", "PLURONIC L-72", "PLURONIC L-101", "PLURONIC L-121", "PLURONIC P-84", "PLURONIC P-85", "PLURONIC P-103", "PLURONIC F-68", "PLURONIC F-88", "PLURONIC F-108", "PLURONIC 25R-1", "PLURONIC 25R-2", "PLURONIC 17R-2", "PLURONIC 17R-3", and "PLURONIC 17R-4" (polyoxyethylene polyoxypropylene glycol) manufactured by ADEKA Corp.; and "KF-6011", "KF-6011P", "KF-6012", "KF-6013", "KF-6015", "KF-6016", "KF-6017", "KF-6017P", "KF-6043", "KF-6004", "KF351A", "KF352A", "KF353", "KF354L", "KF355A", "KF615A", "KF945", "KF-640", "KF-642", "KF-643", "KF-644", "KF-6020", "KF-6204", "X22-4515", "KF-6028", "KF-6028P", "KF-6038", "KF-6048", and "KF-6025" (polyalkylene oxide-modified silicone) manufactured by Shin-Etsu Silicone Co. Ltd.

A compound represented by the following formula (3) may be contained as the component (H): 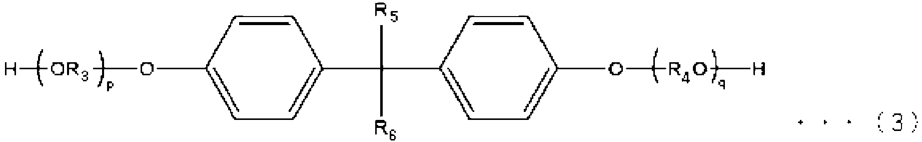 wherein R₃ and R₄ are each independently an alkyl group having 1 to 12 carbon atoms, and R₃ and R₄ are the same as or different from each other; p and q are each independently an integer of 1 or larger; and R₅ and R₆ are each independently one member selected from the group consisting of a hydrogen atom, an alkyl group having 1 to 20 carbon atoms and optionally having a substituent, a cycloalkyl group having 6 to 20 carbon atoms and optionally having a substituent, and an aryl group having 6 to 20 carbon atoms and optionally having a substituent, and R₅ and R₆ are the same as or different from each other.

In the formula (3), p and q are not particularly limited, and the total value of these numbers of repeats, p + q, is, for example, preferably 2 or larger and 12 or smaller, more preferably 3 or larger and 10 or smaller, further preferably 4 or larger and 8 or smaller, still further preferably 5 or larger and 8 or smaller, from the viewpoint of the balance between cured product strength and toughness.

The compound represented by the formula (3) is preferred because the compound is excellent in compatibility with the component (A) and can achieve the imparting of heat resistance and strength ascribable to an aromatic ring moiety in the structure and low stress and low warpage ascribable to a polyalkylene oxide chain moiety.

Examples of the compound represented by the formula (3) include, but are not limited to, trade names: NEWPOL BPE-20, BPE-40, BPE-60, BPE-100, BPE-180, BP-2P, BP-3P, and BP-5P manufactured by Sanyo Chemical Industries, Ltd. One of these compounds may be used singly, or two or more thereof may be used in combination.

The component (H) may be independently added and mixed with components other than the component (H), or a constituent material containing the component (H) may be used to form the component (H) in the system at the time of production of the component (A) or at the time of production of the epoxy resin composition comprising the component (A).

The content of the component (H) in the epoxy resin composition of the present embodiment can be appropriately set depending on desired performance and is not particularly limited. The content is preferably 1% by mass or more and 50% by mass or less, more preferably 1.5% by mass or more and 40% by mass or less, further preferably 2% by mass or more and 30% by mass or less, in all involatile components except for a solvent. The content of the component (H) falls within the range mentioned above, whereby heat resistance, strength, low stress, and low warpage tend to be able to be achieved.

### (Additive)

The epoxy resin composition of the present embodiment may further comprise, if necessary, an additive such as a diluent, a reactive diluent, a pigment, a dye, a flow adjuster, a thickener, a reinforcing agent, a mold release agent, a wetting agent, a flame retardant, a surfactant, a stabilizer, or an adhesion promoter, in addition to the components (A) to (H) mentioned above.

Examples of the diluent include, but are not limited to, dioctyl phthalate, dibutyl phthalate, and benzyl alcohol.

The reactive diluent is a compound having a reactive functional group capable of being integrated into a curing structure such as an epoxy group or an acrylic group, and is a compound effective for reducing the viscosity of the epoxy resin composition of the present embodiment by addition into the epoxy resin composition.

Examples of the reactive diluent include, but are not limited to, acrylate compounds and epoxy compounds capable of reducing a viscosity without impairing reactivity.

Examples of the acrylate compound serving as the reactive diluent include, but are not limited to, compounds having (meth)acryloyl groups at both ends of polyalkylene oxide, polyethylene glycol di(meth)acrylate, polypropylene glycol di(meth)acrylate, polybutylene glycol di(meth)acrylate, trimethylolpropane-type polyfunctional (meth)acrylate, pentaerythritol-type polyfunctional (meth)acrylate, and dipentaerythritol-type polyfunctional (meth)acrylate.

Examples of the epoxy compound serving as the reactive diluent include, but are not limited to, n-butyl glycidyl ether, tert-butyl glycidyl ether, diglycidyl aniline, N,N'-glycidyl-o-toluidine, phenyl glycidyl ether, cresyl glycidyl ether, p-tert-butyl phenyl glycidyl ether, styrene oxide, ethylene glycol diglycidyl ether, propylene glycol diglycidyl ether, and 1,6-hexanediol diglycidyl ether.

Various monoepoxy compounds or glycidyl ether compounds of polyhydric alcohols may be used as the reactive diluent. However, these compounds have, in one molecule, only one functional group (epoxy group or glycidyl group) that contributes to reaction with the component (B) and the component (D), and tend to be unable to attain a sufficient glass transition temperature or toughness of the epoxy resin composition because these compounds cannot form a three-dimensional cross-link at the time of curing, though not responsible for voids by volatilization. Accordingly, the reactive diluent is preferably a compound containing two or more glycidyl groups in one molecule from the viewpoint of being able to form a three-dimensional cross-link at the time of curing.

One of these reactive diluents may be used singly, or two or more thereof may be used in combination.

The content of the reactive diluent can be appropriately set depending on desired performance and is not particularly limited. The content is preferably 1.0 part by mass or more and 30 parts by mass or less with respect to 100 parts by mass of the epoxy resin (A). The content is 1.0 part by mass or more, whereby sufficient low viscous curing is obtained, and the filling properties of a resin paste into space and the close contact of a resin film tend to be favorable. On the other hand, the content of the reactive diluent is 30 parts by mass or less with respect to 100 parts by mass of the epoxy resin (A), whereby the crawling up of a resin paste or its leakage to an unintended location due to excessive reduction in viscosity is prevented, and a resin film can have favorable dimensional stability while peeling tends to be suppressed at the time of a moisture reflow test. It is also preferred to further contain the reactive diluent for the purpose of suppressing elevation in viscosity resulting from high filling of the filler (C).

Examples of the pigment include, but are not limited to, kaolin, chalk powders, gypsum, antimony trioxide, penton, aerosol, lithopone, baryte, and titanium dioxide.

Examples of the dye include, but are not limited to, natural dyes including plant-derived dyes such as madder and indigo, and mineral-derived dyes such as ocher and bole, and synthetic dyes such as alizarin and indigo as well as fluorescent dyes.

Examples of the flow adjuster include, but are not limited to: organic titanium compounds such as titanium tetraisopropoxide and titanium diisopropoxy bis(acetylacetonate); and organic zirconium compounds such as zirconium tetra-normal butoxide and zirconium tetraacetylacetonate.

Examples of the thickener include, but are not limited to: animal-derived thickeners such as gelatin; plant-derived thickeners such as polysaccharides and cellulose; and chemical synthetic thickeners such as polyacrylic thickeners, modified polyacrylic thickeners, polyether-based thickeners, urethane-modified polyether-based thickeners, and carboxymethylcellulose.

Examples of the reinforcing agent include, but are not limited to: polyethylene sulfone powders such as "SUMIKAEXCEL PES" manufactured by Sumitomo Chemical Co., Ltd.; and silicone-based reinforcing agents such as functional group-modified core-shell rubber nanoparticles (e.g., "KANEACE MX" manufactured by Kaneka Corp.) and polyorganosiloxane.

Examples of the mold release agent include, but are not limited to, fluorine-based mold release agents, silicone-based mold release agents, and acrylic mold release agents composed of copolymers of glycidyl (meth)acrylate and linear alkyl (meth)acrylate having 16 to 22 carbon atoms.

Examples of the wetting agent include, but are not limited to, unsaturated polyester copolymer-based wetting agents having an acidic group, such as acrylic polyphosphoric acid ester.

Examples of the flame retardant include, but are not limited to, bromine-based flame retardants, phosphorus-based flame retardants, and inorganic flame retardants.

Examples of the bromine-based flame retardant include, but are not particularly limited to, tetrabromophenol.

Examples of the phosphorus-based flame retardant include, but are not particularly limited to, 9,10-dihydro-9-oxa-10-phosphaphenanthrene-10-oxide and its epoxy derivatives, triphenylphosphine and its derivatives, phosphoric acid ester, condensed phosphoric acid ester, and phosphazene compounds.

Examples of the nitrogen flame retardant include, but are not particularly limited to, melamine polyphosphate, isocyanuric acid, guanidine-based flame retardants, and triazine-based flame retardants.

Examples of the inorganic flame retardant compound include, but are not particularly limited to, magnesium hydroxide and aluminum hydroxide. One of these flame retardants may be used singly, or two or more thereof may be used in combination.

The content of the flame retardant is not particularly limited and is preferably 5.0 parts by mass or more and 200 parts by mass or less, more preferably 10 parts by mass or more and 100 parts by mass or less, with respect to the mass (100 parts by mass) of the epoxy resin (A).

Examples of the surfactant include, but are not limited to, anionic surfactants such as alkyl benzenesulfonate and alkyl polyoxyethylene sulfate, cationic surfactants such as alkyl dimethylammonium salt, amphoteric surfactants such as alkyldimethylamine oxide and alkylcarboxybetaine, and nonionic surfactants such as linear alcohols having 25 or more carbon atoms and fatty acid ester.

For example, boric acid, a cyclic boric acid ester compound, isocyanuric acid, barbituric acid, or an aluminum chelating agent, which improves the storage stability of the epoxy resin composition, can be suitably used as the stabilizer, though the stabilizer is not particularly limited thereto. The cyclic boric acid ester compound contains boric acid in a cyclic structure. The cyclic boric acid ester compound is preferably 2,2'-oxybis(5,5'-dimethyl-1,3,2-oxaborinane) from the viewpoint of compatibility with a resin and uniform curability.

One of these stabilizers may be used singly, or two or more thereof may be used in combination.

Components can be widely used as the adhesion promoter as long as the components are added for the purpose of forming a coordination bond with a metal or a substrate material or improving affinity. A thiazole compound or a triazole compound is preferred from the viewpoint of further obtaining an effect of forming a favorable film on adherend surface and enhancing close contact.

The amount of the aforementioned additive added can be a functionally equivalent amount. For example, the pigment and/or the dye is added in an amount that can offer a desired color to the epoxy resin composition of the present embodiment. Those skilled in the art can appropriately set a proper amount of the additive added depending on the contents of formulation or desired performance.

### [Epoxy resin composition and resin paste comprising same]

The epoxy resin composition of the present embodiment and a resin paste comprising the same contain the component (A) and the component (B) mentioned above and are obtained by mixing these components, if necessary, with the components (C) to (G) and the additive mentioned above.

Specifically, the resin paste of the present embodiment contains the epoxy resin composition of the present embodiment.

The mixing method is not particularly limited, and a method known to those skilled in the art can be applied thereto. The epoxy resin composition or the resin paste can be obtained by thoroughly mixing the components until homogeneous using, for example, but not limited to, a mixing roll such as triple rolls, a dissolver, a planetary mixer, a rotary mixer, a kneader, or an extruder.

### (Specific aspects of epoxy resin composition and resin paste comprising same)

The epoxy resin composition of the present embodiment has completely uniform and sufficient filling properties and can suppress reduction in modulus of elasticity at a high temperature, in addition to having a high glass transition temperature, even when a polyfunctional epoxy resin is blended thereinto, and as such, can be suitably used as a resin paste serving as a sealing material for electric and electronic components, such as an underfill material or a relay sealing material, various insulating liquid adhesives, a paste material for die attach pastes, conductive pastes, thermally conductive pastes, and the like, an ink material for solder resist ink, hole-plugging ink, and the like, a matrix resin for fiber-reinforced plastics, or an impregnant fixative for motor coils.

The epoxy resin composition of the present embodiment, for example, in an underfill material, has completely uniform and sufficient filling properties and can therefore secure penetrability in penetrating into between a semiconductor chip and a substrate by heating, particularly, can fill into a semiconductor chip having a large area or narrow space. In addition, the epoxy resin composition exerts a high glass transition temperature and can suppress reduction in modulus of elasticity at a high temperature and therefore easily endures the heat generation of electronic components or long-term use. The epoxy resin composition is more suitable because the epoxy resin composition can provide an underfill material and semiconductor equipment excellent in long-term connection reliability.

The epoxy resin composition of the present embodiment which is completely homogeneous, for example, in a paste material for die attach pastes, conductive pastes, thermally conductive pastes, and the like, or an ink material, is excellent in strength and long-term durability and is more suitable because the epoxy resin composition allows a cured product having high uniform curability to be obtained without generating particle residues in coating or filling with a paste or ink. The filler (C) for use in the present embodiment is properly selected depending on a purpose and supplemented with silica or one or two or more conductive fillers or thermally conductive fillers, whereby desired die attach properties, conductivity, or thermal conductivity may be imparted thereto while the advantageous effects of the present invention are obtained.

### [Resin film]

The epoxy resin composition of the present embodiment can be prepared into a resin film.

The resin film of the present embodiment has a support and a resin layer comprising the epoxy resin composition of the present embodiment mentioned above on the support. Specifically, the resin film of the present embodiment has, for example, a predetermined support and a resin layer formed on the support from the epoxy resin composition mentioned above and may have, if necessary, a protective layer, specifically, a protective layer on the surface, opposite to the support, of the resin layer.

### (Support)

The support constituting the resin film is preferably a material that resists a temperature at the time of solvent drying.

Examples of such a support include, but are not limited to, polyethylene terephthalate films, polyvinyl alcohol films, polyvinyl chloride films, vinyl chloride copolymer films, polyvinylidene chloride films, vinylidene chloride copolymer films, methyl polymethacrylate copolymer films, polystyrene films, polyacrylonitrile films, styrene copolymer films, polyamide films, and cellulose derivative films.

These films may be drawn, if necessary, for use.

### (Protective layer)

The protective layer is preferably a material that can sufficiently maintain the surface smoothness of the resin layer constituting the resin film.

Such a protective layer is not limited, and, a polyethylene film, a polypropylene film, a polyethylene terephthalate film treated for easy peeling, an oriented polypropylene film, or the like can be preferably used.

### (Method for producing resin film)

The resin film of the present embodiment can be produced by sequentially laminating the support and the resin layer and, if necessary, the protective layer.

A known method can be adopted as a method for laminating the support, the resin layer, and the protective layer.

Specifically, without being particularly limited to, for example, the epoxy resin composition of the present embodiment supplemented with the solvent (F) is prepared. First, a support is coated therewith by use of a known method such as an applicator, a bar coater, a lip coater, a die coater, a roll coater, or a doctor blade coater, and dried to form a resin layer on the support. Examples of the drying method include, but are not particularly limited to, ovens and blasting of hot air. The drying temperature or time is not particularly limited. The drying is preferably performed within a temperature range of 50°C to 160°C and within a drying time of 1 minute to 30 minutes and more preferably performed at 80°C to 150°C for 3 minutes to 25 minutes, from the viewpoint of suppressing the deformation of the support by excessive heating and extra reaction of the resin layer at the time of drying while thoroughly removing the solvent. The drying temperature may be a constant temperature or may have a temperature gradient. Subsequently, a protective layer can be laminated, if necessary, onto the formed resin layer to produce a resin film.

### (Specific aspect of resin film)

The resin film of the present embodiment can be used as, for example, but not limited to, an interlayer insulating film, a film-type solder resist, a sealing sheet, a die attach film, a conductive film, an anisotropically conductive film, a nonconductive film, or a thermally conductive film.

The resin film comprising the epoxy resin composition of the present embodiment not only possesses stability of various kinds required for resin film production, such as stability at the time of varnish storage up to coating and drying, stability at a drying temperature, and film storage stability, but has sufficient filling properties and possesses even low warpage of a cured layer, a high glass transition temperature, and a function of suppressing reduction in modulus of elasticity in a high-temperature region, and as such is effective for materials, particularly, for resin films, which must secure reliability for a thin cured layer moiety. Since the component (B) is uniformly dissolved in the epoxy resin composition or a solvent, the resin film is excellent in surface smoothness and can also be attached in close contact to a base material without space.

These characteristics are required in common for interlayer insulating films, film-type solder resists, sealing sheets, die attach films, conductive films, anisotropically conductive films, nonconductive films, and thermally conductive films. Therefore, the resin film of the present embodiment is suitable for these aspects.

### [Cured product]

The cured product of the present embodiment is prepared by curing the epoxy resin composition mentioned above.

### [Semiconductor equipment]

The semiconductor equipment of the present embodiment comprises a semiconductor device sealed or bonded using the resin paste mentioned above, or comprises a semiconductor device sealed or bonded using the resin film mentioned above. Thus, the semiconductor equipment of the present embodiment has a cured product layer of the epoxy resin composition mentioned above.

Use of the epoxy resin composition of the present embodiment achieves uniform sealing or adhesion and allows a cured product layer to have a high glass transition temperature and to suppress reduction in modulus of elasticity in a high-temperature region. Therefore, semiconductor equipment excellent in reliability that endures the heat generation and long-term use of the semiconductor equipment can be prepared and is thus preferred.

The semiconductor equipment is not particularly limited as long as the device functions by integration into semiconductor components. Examples thereof include various semiconductor equipment for use in electronics such as personal computers, smart phones, gaming consoles, digital cameras, and televisions, vehicles such as motorcycles, automobiles, trains, ships, and aircrafts, and antennas and servers for high-speed communications, etc.

The semiconductor equipment of the present embodiment can be produced, for example, but not particularly limited to, by mounting various semiconductor chips to locations where the circuit connection of the wiring board is performed so as to create conduction.

Specific examples of the method for mounting the semiconductor chip in producing the semiconductor equipment include, but are not particularly limited to, wire bonding mounting methods, flip chip mounting methods, mounting methods using bumpless buildup layers (BBUL), mounting methods using anisotropically conductive films, and mounting methods using nonconductive films.

For mounting, the semiconductor chip can be subjected to sealing, adhesion, and the like using the epoxy resin composition of the present embodiment and the resin paste or the resin film comprising the same.

### Examples

Hereinafter, the present embodiment will be described with reference to specific Examples and Comparative Examples. However, the present invention is not limited by Examples and Comparative Examples given below and may be appropriately changed or modified without departing from the spirit of the invention.

In the description below, "part" and "%" are mass-based unless otherwise specified.

### [Preparation of epoxy resin composition]

Components were each weighed into parts of blending shown in the components of Tables 1 and 2 described below, and mixed until thoroughly homogeneous to obtain an epoxy resin composition.

### (Calculation of parameter α (reaction sensitivity) of epoxy resin composition)

Two temperatures T, 130°C and 150°C, were selected as to the epoxy resin composition mentioned above, and the viscosity of the epoxy resin composition was measured over time at each selected temperature kept constant under an oscillation (f = 1 Hz) condition using a rheometer. The time t minute for the viscosity to reach 10000 Pa·s based on a time when the temperature T°C (130°C or 150°C) was attained was measured. The measurement apparatus used was HAAKE MARS manufactured by Thermo Fisher Scientific Inc. When a solvent was contained as the component (F), each sample was heated at 130°C or 150°C for 3 minutes to evaporate the solvent. The resulting epoxy resin composition was subjected to the measurement.

Next, 1/T was assigned to the abscissa, and Lnt was assigned to the ordinate. The value of Lnt against 1/T obtained as described above was plotted. An approximate line was created by the least squares method for plotted data points, and α was calculated as the slope of the line.

However, if the viscosity did not reach 10000 Pa·s after a lapse of 30 minutes at 130°C, the epoxy resin composition was judged as having insufficient reaction sensitivity in a practical temperature range and thus described as "unevaluable" in the tables.

### [Methods for measuring and evaluating characteristics]

### (Evaluation of homogeneity: appearance inspection)

Components except for the component (C) shown in Tables 1 and 2 were each weighed and mixed until thoroughly homogeneous to obtain an epoxy resin composition free from the component (C). The obtained resin composition was transferred to a transparent plastic container, visually observed from the side, and evaluated such that the homogeneity of the composition was favorable if the composition was completely transparent and was free from a site with a different color, layer separation, and a floated or precipitated solid component. In this case, the homogeneity was indicated by ○ in the tables. The composition was also evaluated such that the homogeneity of the composition was poor if the composition had an opaque site or a site with a different color, layer separation, or a floated or precipitated solid component. In this case, the homogeneity was indicated by × in the tables.

### (Evaluation of filling properties: measurement of low-viscosity holding time at 130°C)

The viscosity of the prepared epoxy resin composition was measured over time at 130°C kept constant under an oscillation (f = 1 Hz) condition using a rheometer, and a time was measured from the smallest viscosity of the resin composition to a viscosity 10 times the smallest viscosity. The measurement apparatus used was HAAKE MARS manufactured by Thermo Fisher Scientific Inc. When a solvent was contained as the component (F), each sample was heated at 130°C for 3 minutes to evaporate the solvent. The resulting resin composition was subjected to the measurement.

The filling properties were evaluated as being favorable if the time to reach the viscosity 10 times the smallest one was 5 minutes or longer. In this case, the filling properties were indicated by ○ in the tables. The filling properties were evaluated as being poor if the time to reach the viscosity 10 times the smallest one was shorter than 5 minutes. In this case, the filling properties were indicated by × in the tables.

### (Evaluation of heat resistance: measurement of glass transition temperature)

As for the prepared epoxy resin compositions of Examples 1 to 10 and Comparative Examples 1 to 8, a U shaped Teflon(R) mold was sandwiched between two 750 mm long × 750 mm wide × 0.5 mm thick aluminum plates coated with a mold release agent in advance to prepare a mold having a 550 mm long × 350 mm wide × 2 mm thick space. Each epoxy resin composition was thoroughly poured into the mold up to the opening and cured by heating for 1 hour in an oven preheated to 150°C. As for Examples 11 to 14 and Comparative Examples 9 to 12, a central portion of aluminum foil having a length of 15 cm, a width of 8 cm, and a thickness of 1.7 mm was coated with an epoxy resin composition layer having a length of 12 cm, a width of 5 cm, and a dry film thickness of 150 µm, and then dried by heating for 5 minutes in an oven preheated to 120°C to form a film. Then, the film was cured by heating for 1 hour in an oven preheated to 150°C.

Each cured product obtained by removal from the Teflon(R) mold or the aluminum foil was subjected to DMA measurement (RSA-G2, manufactured by TA Instruments, Inc.) from 25°C to 250°C at a temperature increase rate of 4°C/min. A temperature at which tanδ assumed the maximum value was regarded as a glass transition temperature.

The glass transition temperature was evaluated as being favorable for 150°C or higher and lower than 200°C and evaluated as being more favorable for 200°C or higher.

However, if tanδ did not assume the maximum value from 25°C to 250°C, the glass transition temperature was regarded as exceeding 250°C and indicated by >250 in the tables. If the cured product was fragile and a test specimen could not be prepared therefrom, the cured product was described as "unevaluable" in the tables.

### (Evaluation of reliability: measurement of rate of maintenance of modulus of elasticity between before and after glass transition temperature)

The epoxy resin composition was cured by the method described in the section (Evaluation of heat resistance) to obtain a cured product. Then, the cured product was subjected to DMA measurement (RSA-G2, manufactured by TA Instruments, Inc.) from 25°C to 250°C at a temperature increase rate of 4°C/min. A storage modulus at 25°C (ordinary-temperature modulus of elasticity) and the minimum value (high-temperature storage modulus) of a storage modulus in a temperature zone equal to or higher than the glass transition temperature measured in the section (evaluation of heat resistance) were measured, and the rate of maintenance of the modulus of elasticity between before and after the glass transition temperature was calculated according to the following mathematical expression (1). 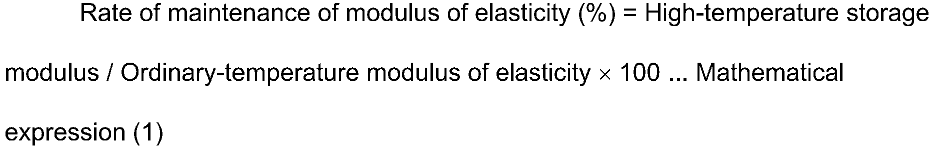 Rate of maintenance of modulus of elasticity (%) = High-temperature storage modulus/Ordinary-temperature modulus of elasticity × 100

The rate of maintenance of the modulus of elasticity was evaluated as being favorable for more than 10% and indicated by ○ in the tables. The rate of maintenance of the modulus of elasticity was evaluated as being poor for 10% or less and indicated by × in the tables. However, if the cured product was fragile and a test specimen could not be prepared therefrom, the cured product was described as "unevaluable" in the tables.

### [[Component description]

Hereinafter, each component in Tables 1 and 2 described below will be shown as a component used in the epoxy resin compositions of Examples and Comparative Examples.

### (Component (A): epoxy resin)

A-1: jER630LSD (glycidyl amine-type epoxy resin, trifunctional, epoxy equivalent: 95 g/eq, manufactured by Mitsubishi Chemical Group Corp.)
A-2: jER1032H60 (triphenylmethane-type epoxy resin, trifunctional, epoxy equivalent: 169 g/eq, manufactured by Mitsubishi Chemical Group Corp.)
A-3: CNE220 (o-cresol novolac-type epoxy resin, polyfunctional (trifunctional or higher), epoxy equivalent: 220 g/eq, manufactured by Chang Chun Plastics Co., Ltd.)
A-4: jER828 (BisA-type liquid epoxy resin, difunctional, epoxy equivalent: 190 g/eq, manufactured by Mitsubishi Chemical Group Corp.)
A-5: EXA850CRP (BisA-type liquid epoxy resin, difunctional, epoxy equivalent: 186 g/eq, manufactured by DIC Corp.)
A-6: EXA830CRP (BisF-type liquid epoxy resin, difunctional, epoxy equivalent: 160 g/eq, manufactured by DIC Corp.)
A-7: HP4032D (naphthalene-type liquid epoxy resin, difunctional, epoxy equivalent: 142 g/eq, manufactured by DIC Corp.)
A-8: YX7400N (polytetramethylene glycol diglycidyl ether, difunctional, epoxy equivalent: 440 g/eq, manufactured by Mitsubishi Chemical Group Corp.)
A-9: GOT (glycidyl amine-type liquid epoxy resin, difunctional, epoxy equivalent: 135 g/eq, manufactured by Nippon Kayaku Co., Ltd.)
A-10: CDMDG (cyclohexanedimethanol diglycidyl ether, difunctional, epoxy resin that is also used as a reactive diluent, epoxy equivalent: 136 g/eq, manufactured by Resonac Holdings Corp.)
A-11: AER9000 (special modified epoxy resin, difunctional, epoxy equivalent: 370 g/eq, manufactured by Asahi Kasei Corp.)
A-12: OGSOL EG-280 (fluorene-type liquid epoxy resin, difunctional, epoxy equivalent: 494 g/eq, manufactured by Osaka Gas Chemical Co., Ltd.)

### (Component (B): compound represented by general formula (1) or general formula (2))

B-1: 2-(2-Hydroxyphenyl)imidazole (manufactured by Ambeed, Inc.)
B-2: 2-(2-Hydroxyphenyl)benzimidazole (manufactured by Tokyo Chemical Industry Co., Ltd.)

### (Compound not corresponding to component (B))

R-1: 2MZ-A (2,4-diamino-6-[2-(2-methyl-1-imidazolyl)ethyl]-1,3,5-triazine, manufactured by Shikoku Kasei Holdings Corp.)
R-2: 2MA-OK (isocyanuric acid adduct of 2,4-diamino-6-[2-(2-methyl-1-imidazolyl)ethyl]-1,3,5-triazine, manufactured by Shikoku Kasei Holdings Corp.)
R-3: 2P4MZ (2-phenyl-4-methylimidazole, manufactured by Shikoku Kasei Holdings Corp.)
R-4: 1B2PZ (1-benzyl-2-phenylimidazole, manufactured by Shikoku Kasei Holdings Corp.)
R-5: 2P4MHZ (2-phenyl-4-methyl-5-hydroxymethylimidazole, manufactured by Shikoku Kasei Holdings Corp.)
R-6: KAYAHARD A-A (3,3'-diethyl-4,4'-diamino-diphenylmethane, manufactured by Nippon Kayaku Co., Ltd.)
R-7: ETACURE 100 (diethyltoluenediamine, manufactured by Mitsui Fine Chemicals, Inc.)

### (Component (C): filler)

C-1: SO-E2 (spherical silica filler, average particle size: 0.5 µm, manufactured by Admatechs Co., Ltd.)

### (Component (D): additional curing agent)

D-1: MEH-8000H (liquid phenol novolac resin curing agent, OH group equivalent: 140 g/eq, manufactured by UBE Corp.)
D-2: HF-1M (solid phenol novolac resin curing agent, OH group equivalent: 106 g/eq, manufactured by UBE Corp.)

### (Component (E): thermoplastic resin)

E-1: PKHB (phenoxy resin, weight-average molecular weight: 32000, manufactured by Gabriel PhenoXies)

### (Component (F): solvent)

F-1: methyl ethyl ketone (manufactured by FUJIFILM Wako Pure Chemical Corp.)
F-2: cyclohexanone (manufactured by FUJIFILM Wako Pure Chemical Corp.)

### (Component (G): silane coupling agent)

G-1: KBM-573 (aminosilane-based coupling agent, manufactured by Shin-Etsu Chemical Co., Ltd.)

### (Component (H): non-epoxy group-terminated compound having polyalkylene oxide structure)

H-1: BPE-100 (10 mol ethylene oxide adduct of bisphenol A, liquid at 25°C, structure having hydroxy groups at both ends, manufactured by Sanyo Chemical Industries, Ltd.)

### [Examples 1 to 14] and [Comparative Examples 1 to 12]

Components were blended at the proportions (parts by mass) shown in Tables 1 and 2, and each epoxy resin composition was prepared by the method described above.

Each characteristic of the prepared epoxy resin composition was measured and evaluated by the method described above. The results are shown in Tables 1 and 2.

**[Table 1]**

| Category | Component (parts by mass) | Example 1 | Example 2 | Example 3 | Example 4 | Example 5 | Example 6 | Example 7 | Example 8 | Example 9 | Example 10 | Example 11 | Example 12 | Example 13 | Example 14 |
|---|---|---|---|---|---|---|---|---|---|---|---|---|---|---|---|
| Component (A) Trifunctional or higher polyfunctional epoxy resin | A-1 | 65 | 65 | 62.5 | 62.5 | 62.5 | 62.5 | 100 | 50 | 30 | 30 | | | | |
| | A-2 | | | | | | | | | | | 30 | 30 | 30 | 30 |
| | A-3 | | | | | | | | | | | 10 | 10 | 10 | 10 |
| | A-4 | | | | | | | | | | | | | | |
| | A-5 | | | | | | | | | | | 15 | 15 | 15 | 15 |
| | A-6 | | | | | | | | 50 | 50 | 40 | 15 | 15 | 15 | 15 |
| Component (A) Bifunctional or lower functional epoxy resin | A-7 | | | | | | | | | 20 | 20 | | | | |
| | A-8 | 35 | 35 | 17.4 | 12.4 | 12.4 | 22.4 | | | | | | | | |
| | A-9 | | | 20.1 | 15.1 | 15.1 | 15.1 | | | | | | | | |
| | A-10 | | | | | | | | | | 10 | | | | |
| | A-11 | | | | 10 | | | | | | | | | | |
| | A-12 | | | | | 10 | | | | | | | | | |
| Component (B) | B-1 | 4 | 4 | 4 | 4 | 4 | 4 | 4 | 4 | 2 | 2 | 6 | | 0.4 | |
| | B-2 | | | | | | | | | | | | 6 | | 0.4 |
| Compound not corresponding to component (B) | R-1 | | | | | | | | | | | | | | |
| | R-2 | | | | | | | | | | | | | | |
| | R-3 | | | | | | | | | | | | | | |
| | R-4 | | | | | | | | | | | | | | |
| | R-5 | | | | | | | | | | | | | | |
| | R-6 | | | | | | | | | | | | | | |
| | R-7 | | | | | | | | | | | | | | |
| Component (C) | C-1 | 254 | 266 | 243 | 243 | 243 | 243 | 243 | 243 | 160 | 160 | 300 | 300 | 300 | 300 |
| Component (D) | D-1 | 5 | | | | | | | | | | | | | |
| | D-2 | | | | | | | | | | | | | 42 | 42 |
| Component (E) | E-1 | | | | | | | | | | | 40 | 40 | 40 | 40 |
| Component (F) | F-1 | | | | | | | | | | | 100 | 100 | 150 | 150 |
| | F-2 | | | | | | | | | | | 100 | 100 | 150 | 150 |
| Component (G) | G-1 | 2.54 | 2.66 | 2.43 | 2.43 | 2.43 | 2.43 | 2.43 | 2.43 | 1.6 | 1.6 | 3 | 3 | 3 | 3 |
| Component (H) | H-1 | | 5 | | | | | | 10 | | | | | | |
| Value of parameter α | | 717 | 700 | 762 | 832 | 847 | 838 | 743 | 795 | 795 | 804 | 717 | 769 | 910 | 926 |
| Homogeneity | | ○ | ○ | ○ | ○ | ○ | ○ | ○ | ○ | ○ | ○ | ○ | ○ | ○ | ○ |
| Filling properties | | ○ | ○ | ○ | ○ | ○ | ○ | ○ | ○ | ○ | ○ | ○ | ○ | ○ | ○ |
| Glass transition temperature | | 208 | 216 | 203 | 206 | 200 | 208 | >250 | >250 | 164 | 162 | 184 | 175 | 173 | 172 |
| Rate of maintenance of modulus of elasticity | | ○ | ○ | ○ | ○ | ○ | ○ | ○ | ○ | ○ | ○ | ○ | ○ | ○ | ○ |

**[Table 2]**

| Category | Component (parts by mass) | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 | Comparative Example 11 | Comparative Example 12 |
|---|---|---|---|---|---|---|---|---|---|---|---|---|---|
| Component (A) Trifunctional or higher polyfunctional epoxy resin | A-1 | 30 | 30 | 30 | 50 | | | 100 | 65 | 62.5 | | | |
| | A-2 | | | | | | | | | | 30 | 30 | 30 |
| | A-3 | | | | | | | | | | 10 | 10 | 10 |
| | A4 | | | | | 100 | | | | | | | |
| | A-5 | | | | | | | | | | 15 | 15 | 15 |
| | A-6 | 50 | 40 | 50 | 50 | | | | | | 15 | 15 | 15 |
| Component (A) Bifunctional or lower functional epoxy resin | A-7 | 20 | 20 | 20 | | | | | | | | | |
| | A-8 | | | | | | 100 | | 35 | 17.4 | | | |
| | A-9 | | | | | | | | | 20.1 | | | |
| | A-10 | | 10 | | | | | | | | | | |
| | A-11 | | | | | | | | | | | | |
| | A-12 | | | | | | | | | | | | |
| Component (B) | B-1 | | | | | 5 | 4 | 20 | | | | | |
| | B-2 | | | | | | | | | | | | |
| Compound not corresponding to component (B) | R-1 | | | | | | | | 4 | | | | |
| | R-2 | | | | | | | | | | 6 | | 0.4 |
| | R-3 | | | | | | | | | 4 | | | |
| | R-4 | 2 | 2 | | | | | | | | | 6 | |
| | R-5 | | | | 1 | | | | | | | | |
| | R-6 | | | 32 | 26 | | | | | | | | |
| | R-7 | | | 12 | 19 | | | | | | | | |
| Component (C) | C-1 | 160 | 160 | 225 | 225 | 243 | 243 | 243 | 254 | 243 | 300 | 300 | 300 |
| Component (D) | D-1 | | | | | | | | 5 | | | | |
| | D-2 | | | | | | | | | | | | 42 |
| Component (E) | E-1 | | | | | | | | | | 40 | 40 | 40 |
| Component (F) | F-1 | | | | | | | | | | 100 | 100 | 150 |
| | F-2 | | | | | | | | | | 100 | 100 | 150 |
| Component (G) | G-1 | 1.6 | 1.6 | 2.25 | 2.25 | 2.43 | 2.43 | 2.43 | 2.54 | 2.43 | 3 | 3 | 3 |
| Component (H) | H-1 | | | | | | | | | | | | |
| Value of parameter α | | 506 | 522 | 597 | 514 | 611 | Unevaluable | 1076 | 682 | 488 | 1058 | 2328 | Unevaluable |
| Homogeneity | | ○ | ○ | ○ | × | ○ | ○ | ○ | × | × | × | ○ | × |
| Filling properties | | ○ | ○ | ○ | ○ | × | ○ | × | × | × | × | × | ○ |
| Glass transition temperature | | 144 | 132 | 122 | 117 | 183 | Unevaluable | >250 | 211 | 171 | 137 | 113 | 135 |
| Rate of maintenance of modulus of elasticity | | × | × | × | × | × | Unevaluable | ○ | ○ | ○ | × | × | × |

All the samples of the Example group in which the component (B) and the trifunctional or higher polyfunctional epoxy resin were used in combination and the parameter α satisfied 690 ≤ α ≤ 1000 had sufficient homogeneity and filling properties and had a glass transition temperature exceeding 150°C or exceeding even 200°C as to Examples 1 to 8. Also, the Example group was found to have a sufficient rate of maintenance of the modulus of elasticity.

In Comparative Examples 1 to 4 and 10 to 12 using the compound not corresponding to the component (B), the glass transition temperature was decreased to around 60°C at maximum as compared with the Example group using the component (B), though these comparative examples employed the polyfunctional epoxy resin. The rate of maintenance of the modulus of elasticity was also insufficient. In Comparative Examples 8 and 9, both the homogeneity and the filling properties were insufficient, though the glass transition temperature was sufficient.

Even if the component (B) was used, neither the filling properties nor the rate of maintenance of the modulus of elasticity was satisfactory in Comparative Example 5 using no polyfunctional epoxy resin. Even if the component (B) was used, neither of the glass transition temperature nor the rate of maintenance of the modulus of elasticity was satisfactory in Comparative Example 6 using no polyfunctional epoxy resin. Even if the component (B) and the polyfunctional epoxy resin were used, Comparative Example 7 in which the parameter α did not satisfy 690 ≤ α ≤ 1000 was found to have insufficient filling properties.

Thus, the Example group comprising the trifunctional or higher polyfunctional epoxy resin and the component (B) and having the parameter α that satisfied 690 ≤ α ≤ 1000 produced a homogeneous epoxy resin composition and was able to attain favorable filling properties, glass transition temperature, and rate of maintenance of the modulus of elasticity, and was thus found exceptionally effective.

The present application is based on Japanese Patent Application No. 2023-207573 filed in the Japan Patent Office on December 8, 2023, the contents of which are incorporated herein by reference.

### Industrial Applicability

The epoxy resin composition of the present invention has completely uniform and sufficient filling properties and can suppress reduction in modulus of elasticity at a high temperature, in addition to having a markedly high glass transition temperature exceeding a curing temperature, when a polyfunctional epoxy resin is blended thereinto, and is therefore excellent in high heat resistance and reliability capable of enduring long-term use, and as such, has industrial applicability in the fields of resin paste materials including sealing materials for electric and electronic components, such as underfill materials and relay sealing materials, various insulating liquid adhesives, paste materials for die attach pastes, conductive pastes, thermally conductive pastes, and the like, ink materials for solder resist ink, hole-plugging ink, and the like, matrix resins for fiber-reinforced plastics, and impregnant fixatives for motor coils, and film materials for interlayer insulating films, film-type solder resists, sealing sheets for semiconductor packages, die attach films, conductive films, anisotropically conductive films, nonconductive films, thermally conductive films, and the like.

## Claims

1. An epoxy resin composition comprising
component (A): an epoxy resin, and
component (B): a compound represented by the following formula (1) and/or a compound represented by the following formula (2), wherein
the component (A) comprises at least one trifunctional or higher polyfunctional epoxy resin, and
when a temperature T°C that satisfies 130 ≤ T ≤ 150 is kept constant, a slope α of a line satisfies 690 ≤ α ≤ 1000, the line being obtained by plotting Lnt (ordinate) against 1/T (abscissa) wherein a time for a viscosity to reach 10000 Pa·s based on a time when the temperature T°C has been attained is defined as t minute: 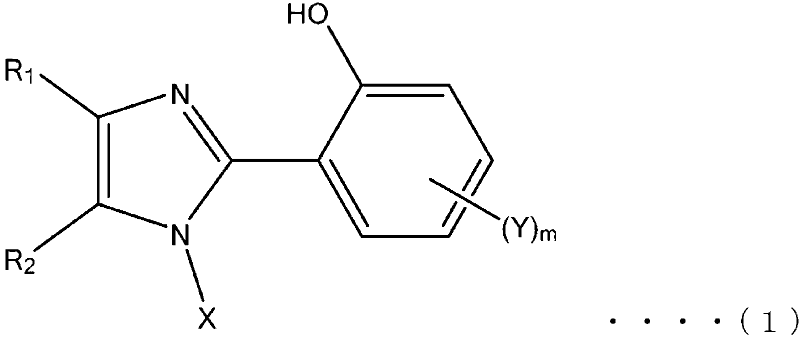 wherein
R₁ and R₂ are each independently any one member selected from the group consisting of a hydrogen atom, a hydroxy group, a carboxy group, a cyano group, a nitro group, a halogen atom, an alkyl group having 1 to 20 carbon atoms and optionally having a substituent, and a cycloalkyl group having 6 to 20 carbon atoms and optionally having a substituent, R₁ and R₂ are the same as or different from each other, and R₁ and R₂ are optionally bonded to each other to form a condensed ring having no aromaticity;
X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent;
Y is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, a plurality of Y moieties, if present, are the same as or different from each other, and two or more Y moieties are optionally bonded to each other to form a monocyclic ring or a condensed ring; and m is an integer of 1 to 4, 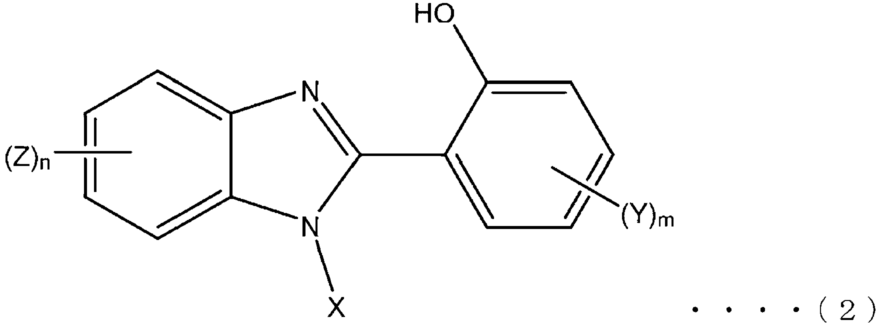 wherein
X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent;
each of Y and Z is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, Y and Z are the same as or different from each other, and two or more Y moieties or two or more Z moieties are optionally bonded to each other to form a monocyclic ring or a condensed ring; and m and n are each independently an integer of 1 to 4.

2. The epoxy resin composition according to claim 1, wherein
the component (A) further comprises a bifunctional or lower functional epoxy resin.

3. The epoxy resin composition according to claim 2, wherein
a blending ratio (mass ratio) between the trifunctional or higher polyfunctional epoxy resin and the bifunctional or lower functional epoxy resin is in a range of 1:0.1 to 1:10.

4. The resin composition according to claim 1, wherein
the component (A) comprises an epoxy resin having an aromatic ring.

5. The resin composition according to claim 1, wherein
the component (A) comprises an epoxy resin having no aromatic ring.

6. The epoxy resin composition according to claim 1, wherein
in the component (B),
Y in the formula (1) is one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an alkoxy group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent, and
each of Y and Z in the formula (2) is one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an alkoxy group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent.

7. The epoxy resin composition according to claim 1, wherein
in the component (B),
the compound represented by the formula (1) is any member selected from the group consisting of 2-(2-hydroxyphenyl)imidazole, 2-(2-hydroxyphenyl)-4(5)-methylimidazole, 4-ethyl-(2-hydroxyphenyl)-5-methylimidazole, (2-hydroxyphenyl)-4-isopropyl-5-methylimidazole, 4-butyl-(2-hydroxyphenyl)-5-methylimidazole, and 2-(2-hydroxy-3(5)-methoxyphenyl)imidazole,
and/or
the compound represented by the formula (2) is any member selected from the group consisting of 2-(2-hydroxyphenyl)benzimidazole, 2-(2-hydroxy-3(5)-methoxyphenyl)benzimidazole, 2-(1-hydroxynaphthalen-2-yl)benzimidazole, 2-(2-hydroxynaphthalen-1-yl)benzimidazole, and 2-(2-hydroxyphenyl)benzimidazole-6-carboxylic acid.

8. The epoxy resin composition according to claim 1, further comprising
component (C): a filler.

9. The epoxy resin composition according to claim 1, further comprising
component (E): a thermoplastic resin.

10. The epoxy resin composition according to claim 1, further comprising
component (G): a silane coupling agent.

11. The epoxy resin composition according to claim 10, wherein the component (G) is an aminosilane-based coupling agent.

12. The epoxy resin composition according to claim 1, further comprising
component (H): a non-epoxy group-terminated compound having a polyalkylene oxide structure.

13. The epoxy resin composition according to claim 12, wherein
the component (H) has a terminal hydroxy group.

14. The epoxy resin composition according to claim 13, wherein
the component (H) is a compound represented by the following formula (3): 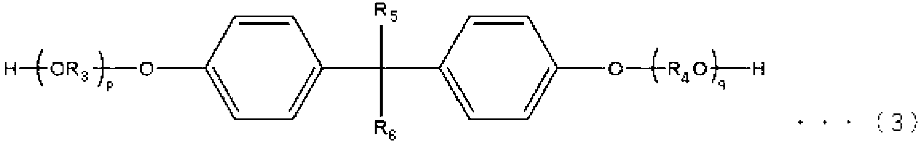 wherein R₃ and R₄ are each independently an alkyl group having 1 to 12 carbon atoms, and R₃ and R₄ are the same as or different from each other; p and q are each independently an integer of 1 or larger; and R₅ and R₆ are each independently one member selected from the group consisting of a hydrogen atom, an alkyl group having 1 to 20 carbon atoms and optionally having a substituent, a cycloalkyl group having 6 to 20 carbon atoms and optionally having a substituent, and an aryl group having 6 to 20 carbon atoms and optionally having a substituent, and R₅ and R₆ are the same as or different from each other.

15. A resin paste comprising
the epoxy resin composition according to any one of claims 1 to 14.

16. A resin film having
a support, and
a resin layer comprising the epoxy resin composition according to any one of claims 1 to 14 on the support.

17. The resin film according to claim 16, further having
a protective layer.

18. A cured product prepared by curing the epoxy resin composition according to any one of claims 1 to 14.

19. Semiconductor equipment having a layer of the cured product according to claim 18.
